(19) Europäisches Patentamt
European Patent Office
Office européen des brevets

(11) EP 4 376 582 A1

(12) # EUROPEAN PATENT APPLICATION

(43) Date of publication:
**29.05.2024 Bulletin 2024/22**

(21) Application number: **22209654.7**

(22) Date of filing: **25.11.2022**

(51) International Patent Classification (IPC):
***H10K 85/30*** (2023.01) ***H10K 50/17*** (2023.01)
*H10K 50/828* (2023.01) *H10K 50/16* (2023.01)

(52) Cooperative Patent Classification (CPC):
**H10K 85/371; H10K 85/30;** H10K 50/16; H10K 50/171; H10K 50/828

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Novaled GmbH
01099 Dresden (DE)**

(72) Inventors:
- **ROSENOW, Thomas
01099 Dresden (DE)**
- **RUNGE, Steffen
01099 Dresden (DE)**
- **UVAROV, Vladimir
01099 Dresden (DE)**
- **PINTER, Piermaria
01099 Dresden (DE)**

(74) Representative: **Michalski Hüttermann & Partner Patentanwälte mbB
Kaistraße 16A
40221 Düsseldorf (DE)**

(54) **ORGANIC ELECTROLUMINESCENT DEVICE AND DISPLAY DEVICE COMPRISING THE ORGANIC ELECTROLUMINESCENT DEVICE**

(57) The present invention relates to an electroluminescent device comprising an electron injection layer (180), comprising a compound of formula (I) and a metal and a display device comprising the organic electroluminescent device.

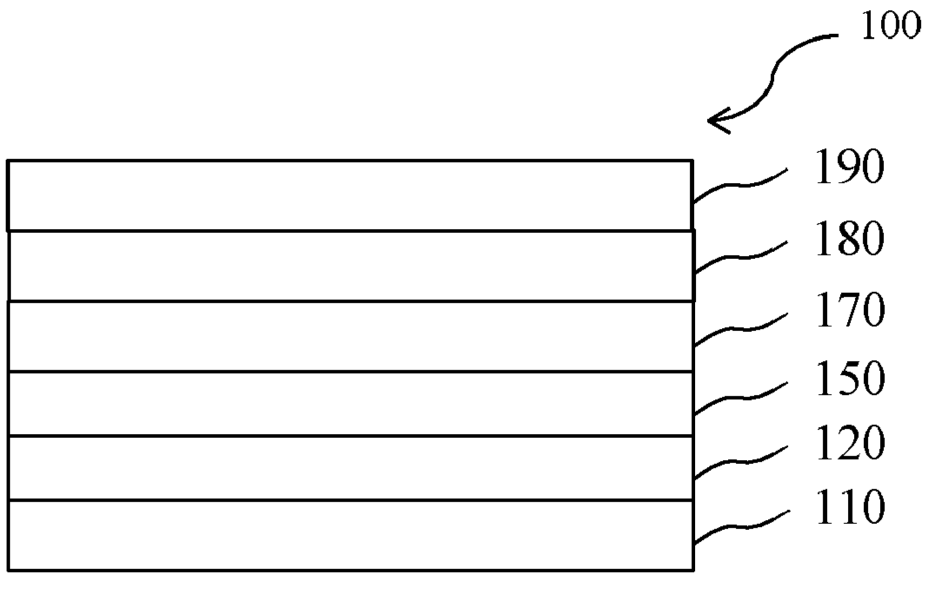


Fig. 1



Processed by Luminess, 75001 PARIS (FR)

## Description

### Technical Field

The present invention relates to an organic electroluminescent device comprising a compound of formula (1) and/or (Ia) and a display device comprising the organic electroluminescent device.

### Background Art

Organic electroluminescent device s, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

There remains a need to improve the performance of an organic electroluminescent device, in particular concerning improved operating voltage, improved color-corrected efficiency, improved lifetime and/or improved voltage stability over time. Furthermore there is a need to provide compounds which are suitable for mass production of organic electroluminescent devices, in particular with regards to thermal properties and/or crystallization tendency upon deposition on a solid substrate. Furthermore there is the need for compounds that potentially have reduced health and safety risks compared to the art.

### DISCLOSURE

An aspect of the present invention provides an organic electroluminescent device comprising an anode layer, a cathode layer, a first emission layer (EML) and an electron injection layer (EIL), wherein the EML and EIL are arranged between the anode layer and the cathode layer and the EIL is in direct contact with the cathode layer, whereby
the EIL comprises at least one compound of formula (I)

$$M^{n\oplus}(L^{\ominus})_n(AL)_m \qquad (I),$$

wherein

M is a metal ion,
n is an integer selected from 1 to 4, which corresponds to the oxidation number of M;
L is an anionic ligand, wherein the proton affinity of L is selected in the range of ≥ 10 eV and ≤ 15.6 eV and wherein L comprises at least four fluorine atoms;
AL is an ancillary ligand;
m is an integer selected from 0 to 2;
whereby the EIL comprises at least one metal; and
whereby cathode layer comprises ≥ 50 vol.-% and ≤ 100 vol.-% Ag.

According to a different aspect of the present invention, an organic electroluminescent device is provided comprising an anode layer, a cathode layer, a first emission layer (EML) and an electron injection layer (EIL), wherein the EML and EIL are arranged between the anode layer and the cathode layer and the EIL is in direct contact with the cathode layer, whereby
the EIL comprises at least one compound of formula (Ia)

$$M^{n\oplus}(L^{\ominus})_n(AL)_m \qquad (Ia),$$

wherein

M is a metal ion,
n is an integer selected from 1 to 4, which corresponds to the oxidation number of M;

L is an anionic ligand comprising at least 15 covalently bound atoms, wherein at least two atoms are selected from carbon atoms, and wherein L comprises at least four fluorine atoms;
AL is an ancillary ligand;
m is an integer selected from 0 to 2;
whereby the EIL comprises at least one metal; and
whereby cathode layer comprises ≥ 50 vol.-% and ≤ 100 vol.-% Ag.

It should be noted that throughout the application and the claims any $A^n$, $B^n$, $R^n$ etc. always refer to the same moieties, unless otherwise noted.
In the present specification, when a definition is not otherwise provided, "substituted" refers to one substituted with a deuterium, $C_1$ to $C_{12}$ alkyl and $C_1$ to $C_{12}$ alkoxy.
However, in the present specification "aryl substituted" refers to a substitution with one or more aryl groups, which themselves may be substituted with one or more aryl and/or heteroaryl groups.
Correspondingly, in the present specification "heteroaryl substituted" refers to a substitution with one or more heteroaryl groups, which themselves may be substituted with one or more aryl and/or heteroaryl groups.
In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.
Specific examples of the alkyl group may be a methyl group, an ethyl group, a propyl group, an iso-propyl group, a butyl group, an iso-butyl group, a tert-butyl group, a pentyl group, a hexyl group.
The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.
The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.
In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.
Analogously, under heteroaryl, it is especially where suitable understood a group derived by formal abstraction of one ring hydrogen from a heterocyclic aromatic ring in a compound comprising at least one such ring.
Under heterocycloalkyl, it is especially where suitable understood a group derived by formal abstraction of one ring hydrogen from a saturated cycloalkyl ring in a compound comprising at least one such ring.
The term "fused aryl rings" or "condensed aryl rings" is understood the way that two aryl rings are considered fused or condensed when they share at least two common $sp^2$-hybridized carbon atoms.
In the present specification, the single bond refers to a direct bond.
In the context of the present invention, "different" means that the compounds do not have an identical chemical structure.
The term "free of', "does not contain", "does not comprise" does not exclude impurities which may be present in the compounds prior to deposition. Impurities have no technical effect with respect to the object achieved by the present invention.
The term "essentially free of' in the context of the present invention means a content of ≤1% (wt/wt), more preferred ≤0.5% (wt/wt) even more preferred ≤0.01% (wt/wt) and most preferred ≤0.05% (wt/wt).
The term "contacting sandwiched" refers to an arrangement of three layers whereby the layer in the middle is in direct contact with the two adjacent layers.
The terms "light-emitting layer", "light emission layer" and "emission layer" are used synonymously.
The terms "organic electroluminescent device", "OLED", "organic light-emitting diode" and "organic light-emitting device" are used synonymously.
The terms anode, anode layer and anode electrode are used synonymously.
The terms cathode, cathode layer and cathode electrode are used synonymously.
In the specification, hole characteristics refer to an ability to donate an electron to form a hole when an electric field is applied and that a hole formed in the anode may be easily injected into the emission layer and transported in the

emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

## Advantageous Effects

Surprisingly, it was found that the organic electroluminescent device according to the invention solves the problem underlying the present invention by enabling devices in various aspects superior over the organic electroluminescent devices known in the art, in particular with respect to operating voltage, color-corrected efficiency, lifetime and/or voltage stability over time. Additionally, it was found that the compounds of formula (I) and/or (Ia) may have improved thermal properties and/or reduced tendency to crystallise upon deposition on a solid substrate compared to the art. Furthermore, the compounds of formula (I) and/or (Ia) may have reduced health and safety risks compared to compounds known in the art.

According to one embodiment of the present invention, the organic electroluminescent device comprises an electron transport layer (ETL), wherein the electron transport layer is arranged between the first emission layer and the electron injection layer, whereby the ETL comprises at least one compound of formula (II)

$$(Ar^2)_m\text{-}(Z_k\text{-}G)_n \qquad (II);$$

whereby m and n are independently 1 or 2;
k is independently 0, 1 or 2;
$Ar^2$ is independently selected from the group consisting of $C_2$ to $C_{42}$ heteroaryl and $C_6$ to $C_{60}$ aryl,

wherein each $Ar^2$ may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
wherein each $C_6$ to $C_{12}$ aryl substituent on $Ar^2$ and each $C_3$ to $C_{11}$ heteroaryl substituent on $Ar^2$ may be substituted with $C_1$ to $C_4$ alkyl or halogen;

Z is independently selected from $C_6$ to $C_{30}$ aryl,
wherein each Z may be substituted with one or two substituents independently selected from the group consisting of $C_6$ to $C_{12}$ aryl and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
wherein each $C_6$ to $C_{12}$ aryl substituent on Z may be substituted with $C_1$ to $C_4$ alkyl or halogen; and
G is chosen so that the dipole moment of a compound G-phenyl is ≥ 1 D and ≤ 7 D.

In the following some layers of the organic electroluminescent device are described in more detail:

*Electron injection layer (EIL)*

According to one embodiment of the present invention, the EIL has a thickness of ≥ 1 nm and ≤ 10 nm.

According to one embodiment of the present invention, the electron injection layer (EIL) comprises a first EIL sub-layer (EIL1) and a second EIL sub-layer (EIL2), wherein the first EIL sub-layer is arranged closer to the anode layer and the second EIL sub-layer is arranged closer to the cathode layer; and wherein the first EIL sub-layer comprises the compound of formula (I) and/or (Ia) and the second EIL sub-layer comprises the metal.

According to one embodiment of the present invention, the EIL is a single layer.

According to one embodiment, the EIL is a single layer and the ratio (in wt/wt) of the compound of formula (I)

and/or (Ia) and the metal is ≥ 1:5 to ≤ 1:20, preferably ≥ 1:8 to ≤ 1:12.

According to one embodiment, the EIL is a single layer and the ratio of metal to compound of formula (I) and/or (Ia) measured in wt,.-% (weight percent) is in the range of 98:2 to 80:20, preferably 95:5 to 85:15.

It is understood that the EIL is not part of the electron transport layer or the cathode layer.

According to an embodiment of the present invention, the metal comprised in the EIL is different from the metal in formulae (I) and/or (Ia).

According to an embodiment of the present invention, the EIL is non-emissive.

Compounds of formulae (I) and/or (Ia).

The compounds of formulae (I) and/or (Ia) is non-emissive. In the context of the present specification the term "essentially non-emissive" or "non-emissive" means that the contribution of the compound according to formulae (I) and/or (Ia) to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

According to one embodiment, the compounds of formulae (I) and/or (Ia) may have a molecular weight Mw of ≥ 287 g/mol and ≤ 2000 g/mol, preferably a molecular weight Mw of ≥ 300 g/mol and ≤ 2000 g/mol.

M of the compounds of formulae (I) and/or (Ia)

According to one embodiment of the present invention, the valency n of M of the compounds of formulae (I) and/or (Ia) is 1, 2 or 3.

According to one embodiment, wherein M of the compounds of formulae (I) and/or (Ia) may be selected from a metal ion wherein the corresponding metal has an electronegativity value according to Allen of less than 2.4.

The term "electronegativity value according to Allen" especially refers to Allen, Leland C. (1989). "Electronegativity is the average one-electron energy of the valence-shell electrons in ground-state free atoms", Journal of the American Chemical Society 111 (25): 9003-9014.

Preferably M may be selected from an alkali, alkaline earth, transition metal, rare earth metal or group III or V metal.

The alkali metals may be selected from the group comprising Li, Na, K, Rb or Cs. The alkaline earth metals may be selected from the group comprising Mg, Ca, Sr or Ba. The transition metals may be selected from Sc, Y, La, Ti, Zr, V, Nb, Ta, Cr, Mo, W, Mn, Re, Fe, Co, Ni, Cu, Ag, Au or Zn. The rare earth metal may be selected from Ce. The group III and V metal may be selected from the group comprising Bi and Al.

According to one embodiment of the present invention, M is selected from Li, Na, K, Rb, Cs, Mg, Cu, Zn, Fe, Ag, Bi and Ce; preferably M is selected from Na, K, Rb, Cu, Zn, Fe and Ag.

According to one embodiment of the present invention, M is not Li or Cs.

Ligand L of formula (I)

According to an embodiment, L is an anionic ligand, wherein the proton affinity of L is selected in the range of ≥ 10 eV and ≤ 15.6 eV, preferably ≥ 11 eV and ≤ 15.5 eV, more preferred ≥ 12 eV and ≤ 15.5 eV.

In the context of this invention, the proton affinity may be determined by performing the steps of

- Calculation of the optimised geometries of the molecule and its deprotonated form; and
- Calculation of the proton affinity of the ligand by determining the energy difference between the optimized structure of the molecule and of its deprotonated form;

whereby the calculations are performed by applying the hybrid functional B3LYP with the 6-31G* basis set in the gas phase as implemented in the program package TURBOMOLE V6.5 (TURBOMOLE GmbH, Litzenhardtstrasse 19, 76135 Karlsruhe, Germany) or in the program package ORCA Version 5.0.3-f.1 (Department of Theory and Spectroscopy, Max Planck Institute für Kohlenforschung Kaiser Wilhelm Platz 1, 45470 Muelheim/Ruhr, Germany); wherein if several conformers of the molecule are viable, the conformer with the lowest total energy is selected.
It should be noted that usually both programs give the same result. If there are deviations, then they are in the range of ± 0.1 eV.

When the proton affinity of L is selected in this range, the electron injection properties of an electron injection layer comprising compound of formula (I) may be in the range suitable for improved performance, in particular low operating voltage, high color-corrected cd/A efficiency, lifetime and/or voltage stability over time.

Ligand L of formula (I) and/or (Ia)

In the following preferred properties of either the ligand L of formula (I) and/or formula (Ia) are described: According to one preferred embodiment of the present invention, L comprises at least four fluorine atoms and less than 60 fluorine atoms, preferably at least six fluorine atoms and less than 60 fluorine atoms.

When L comprises at least four fluorine atoms, the thermal properties of the compound of formula (I) and/or (Ia) may be in the range suitable for mass production of organic electroluminescent devices.

According to one embodiment, n in formula (I) and/or (Ia) is an integer from 1 to 4, preferably 1 to 3, also preferred 1 or 2.

According to one embodiment, the ligand L in compound of formula (I) and/or (Ia) may be selected from a group comprising:

- at least three carbon atoms, alternatively at least four carbon atoms, and/or
- at least two oxygen atoms, preferably two to four oxygen atoms, two to four oxygen atoms and zero to two nitrogen atoms, and/or
- at least one or more groups selected from halogen, F, CN, substituted or unsubstituted $C_1$ to $C_6$ alkyl, substituted or unsubstituted $C_1$ to $C_6$ alkoxy, alternatively two or more groups selected from halogen, F, CN, substituted or unsubstituted $C_1$ to $C_6$ alkyl, substituted or unsubstituted $C_1$ to $C_6$ alkoxy, at least one or more groups selected from halogen, F, CN, substituted $C_1$ to $C_6$ alkyl, substituted $C_1$ to $C_6$ alkoxy, alternatively two or more groups selected from halogen, F, CN, perfluorinated $C_1$ to $C_6$ alkyl, perfluorinated $C_1$ to $C_6$ alkoxy, one or more groups selected from substituted or unsubstituted $C_1$ to $C_6$ alkyl, substituted or unsubstituted $C_6$ to $C_{12}$ aryl, and/or substituted or unsubstituted $C_3$ to $C_{12}$ heteroaryl,

wherein the substituents are selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^3$, $COOR^3$, halogen, F or CN;
wherein $R^3$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy;
wherein L comprises at least four fluorine atoms and less than 60 fluorine atoms.

According to one embodiment of the present invention, in formula (I) and/or (Ia) L is selected from formulas La to Lc:

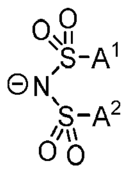 (La), 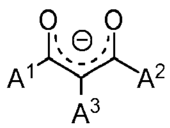 (Lb), and 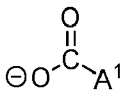 (Lc),

wherein

$A^1$ and $A^2$ are independently selected from substituted or unsubstituted $C_1$ to $C_{12}$ alkyl, substituted or unsubstituted $C_6$ to $C_{12}$ aryl, substituted or unsubstituted $C_3$ to $C_{12}$ heteroaryl;
wherein the substituents of $A^1$ and $A^2$ may be independently selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^1$, $COOR^1$, $SO_2R^1$, halogen, F or CN,
wherein $R^1$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy;
$A^3$ is selected from CN, substituted or unsubstituted $C_1$ to $C_4$ alkyl, especially partially or perfluorinated $C_1$ to $C_4$ alkyl, or whereby $A^3$ is selected as to form a cyclic structure with either $A^1$ or $A^2$, whereby 5- or 6- membered aliphatic or aromatic rings are preferred and whereby the ring may comprise one or more heteroatoms, preferably selected

from N, O and S;
wherein L comprises at least four fluorine atoms and less than 60 fluorine atoms.

The negative charge in ligand L of formulae (I) and/or (Ia) and (La) to (Lc), may be delocalised partially or fully over the $N(SO_2)_2$ group, $NSO_2$ group or $CO_2$ group or CO group and optionally also over the $A^1$, $A^2$ and $A^3$ groups.
According to one embodiment, the ligand L of formula (I) and/or (Ia) may be selected from G1 to G111:

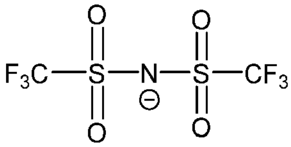,
(G1)

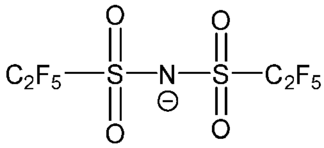,
(G2)

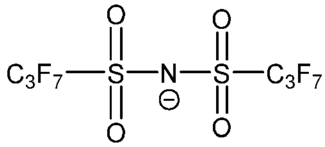,
(G3)

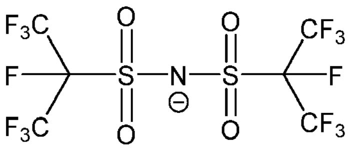,
(G4)

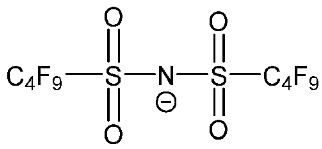,
(G5)

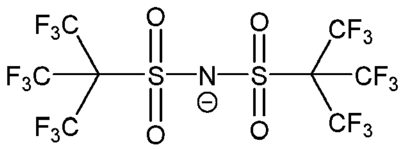,
(G6)

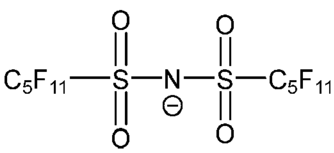,
(G7)

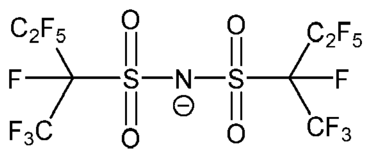,
(G8)

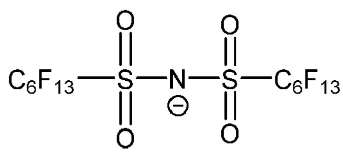,
(G9)

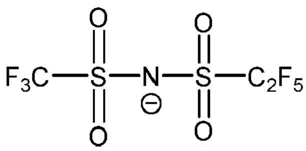,
(G10)

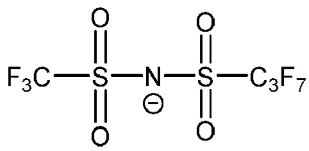,
(G11)

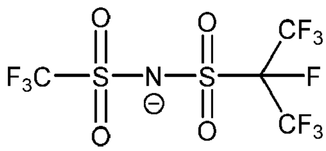,
(G12)

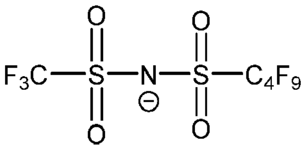,
(G13)

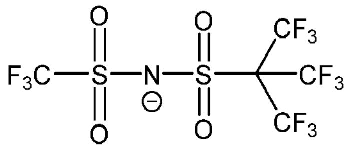,
(G14)

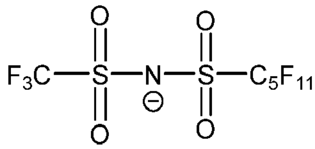,
(G15)

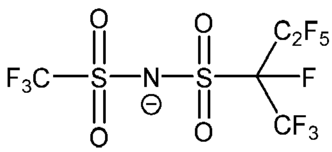,
(G16)

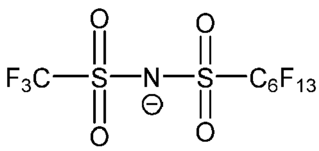,
(G17)

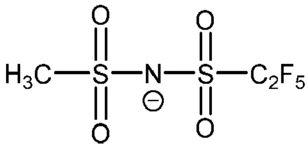,
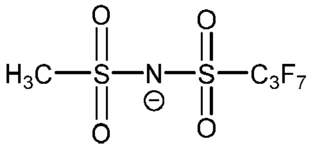,
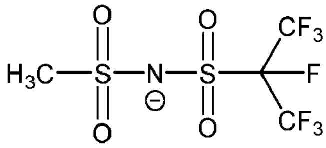,

(G18) (G19) (G20)

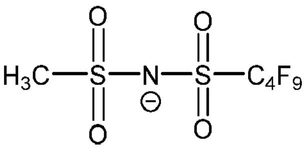,
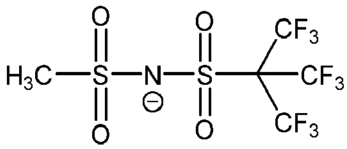,
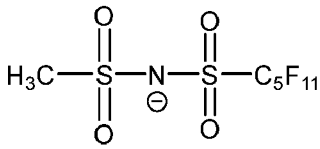,

(G21) (G22) (G23)

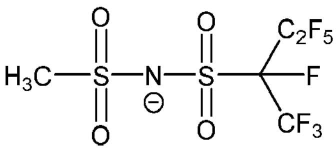,
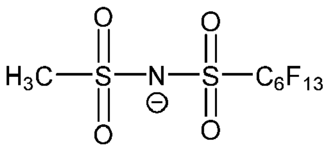,

(G24) (G25)

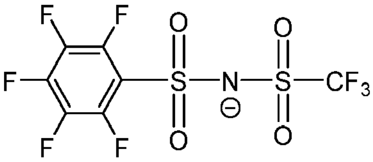,
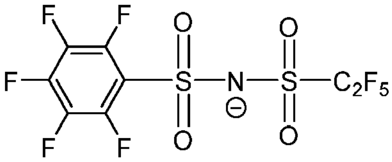,

(G26) (G27)

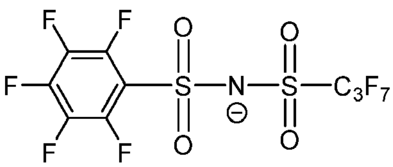,

(G28)

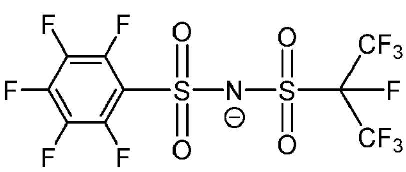,
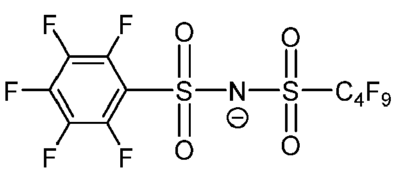,

(G29) (G30)

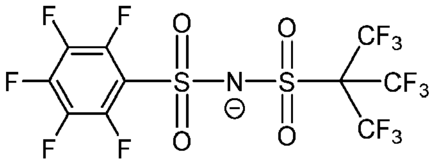,
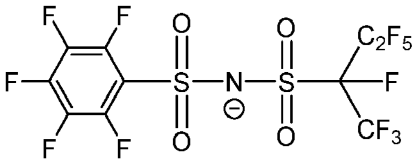,

(G31) (G32)

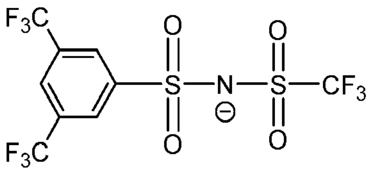,
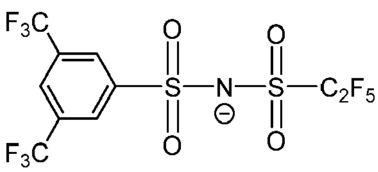,
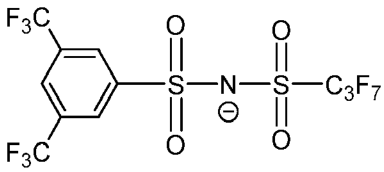,

(G33) (G34) (G35)

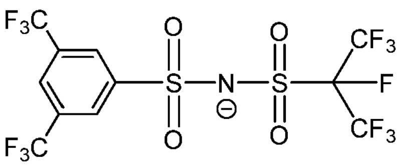,
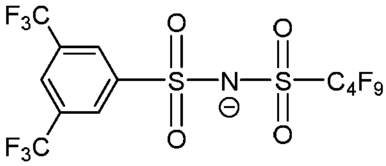,

(G36) (G37)

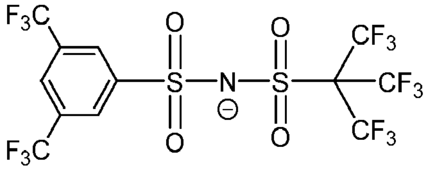,

(G38)

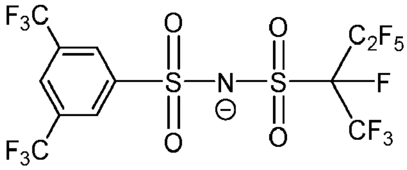,
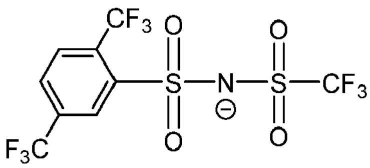,

(G39) (G40)

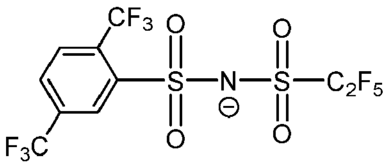,

(G41)

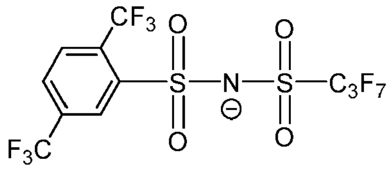, 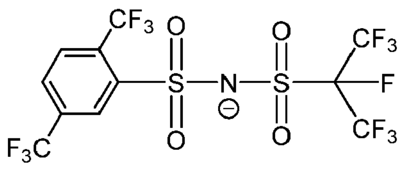,

(G42) (G43)

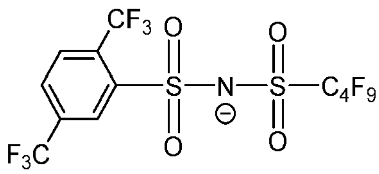, 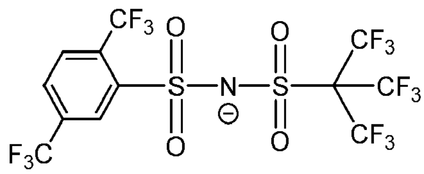

(G44) (G45)

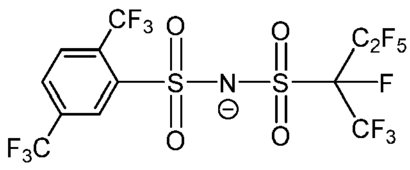, 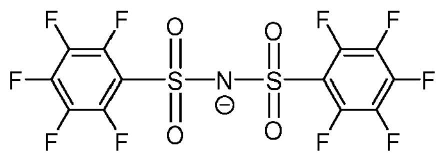

(G46) (G47)

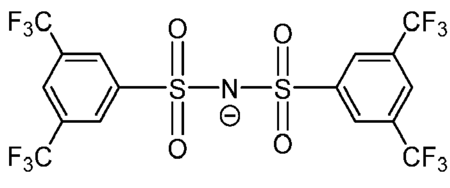, 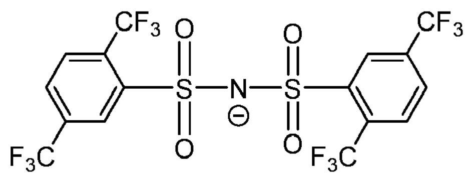,

(G48) (G49)

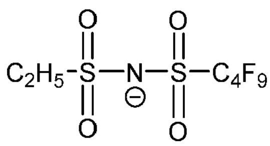, 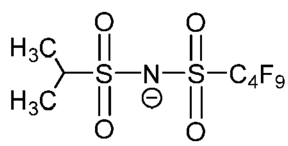, 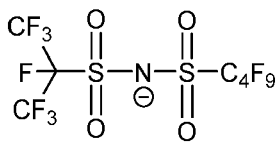,

(G50) (G51) (G52)

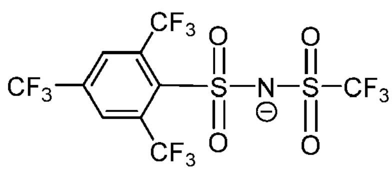

(G53),

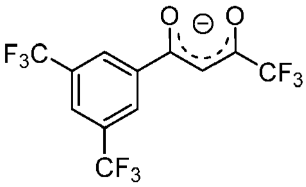,
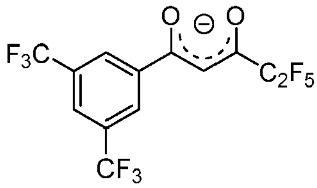,
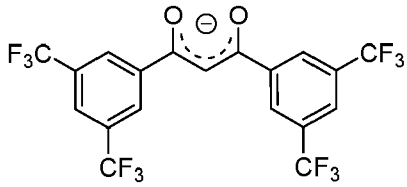,

(G54) (G55) (G56)

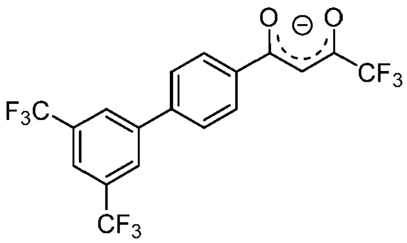,
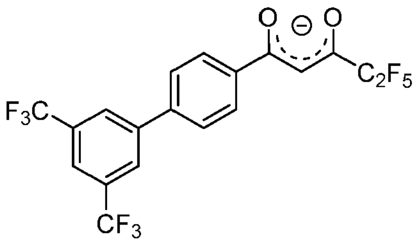,

(G57) (G58)

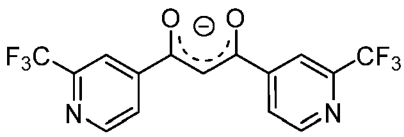,
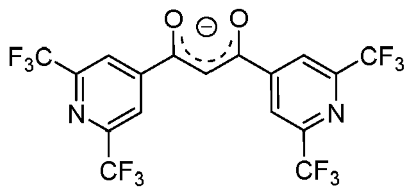,

(G59) (G60)

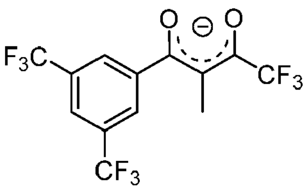,
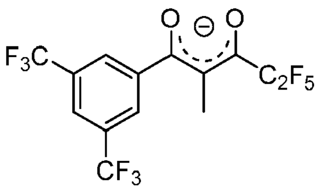,
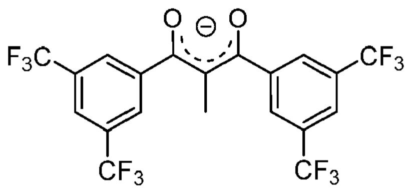,

(G61) (G62) (G63)

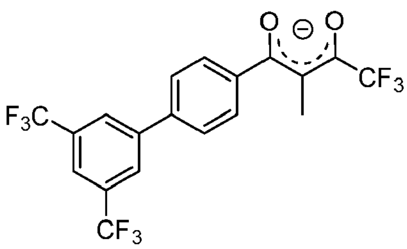,
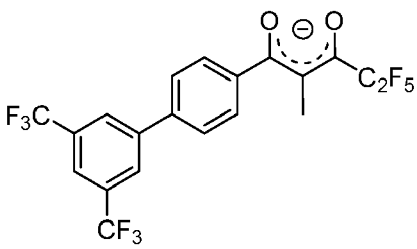,

(G64) (G65)

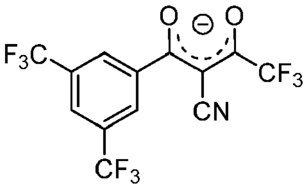 , 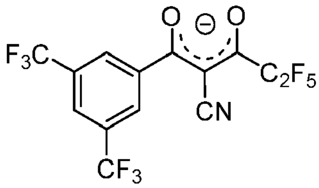 , 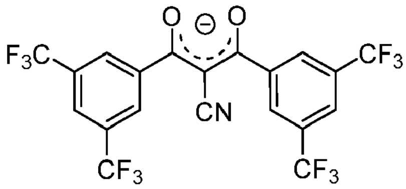 ,

(G66) (G67) (G68)

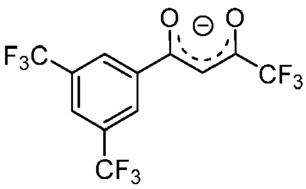 , 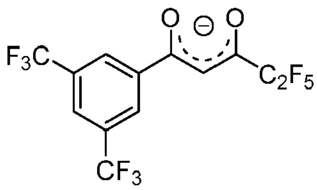 , 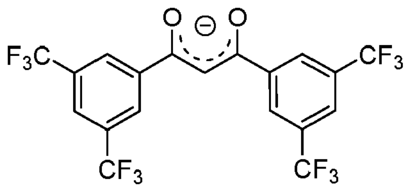 ,

(G54) (G55) (G56)

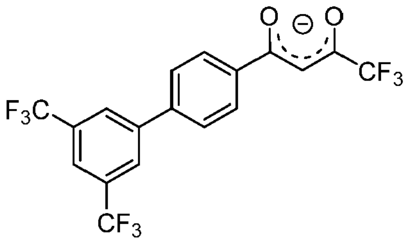 , 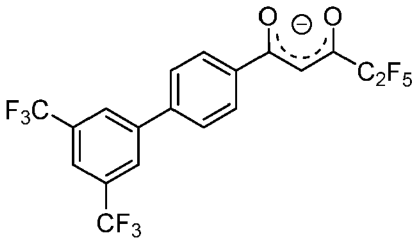 ,

(G57) (G58)

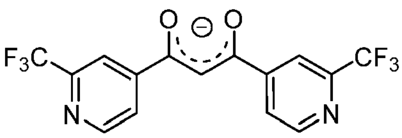 , 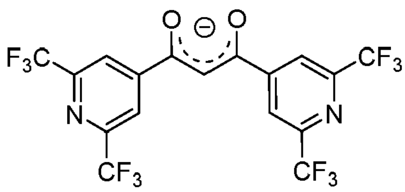 ,

(G59) (G60)

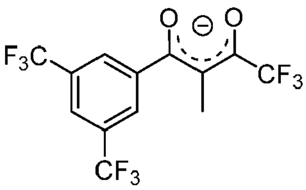 , 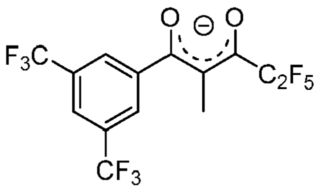 , 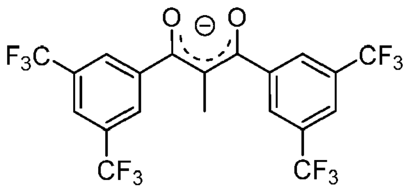 ,

(G61) (G62) (G63)

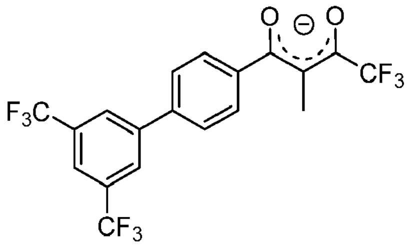,

(G64)

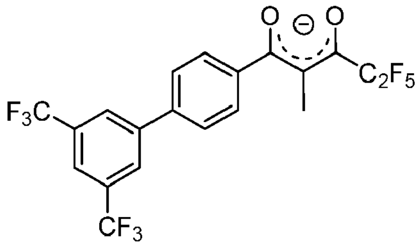,

(G65)

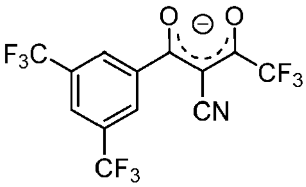,

(G66)

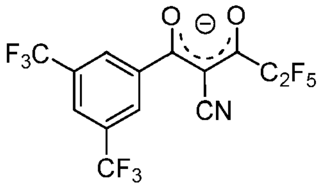,

(G67)

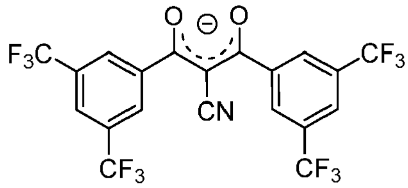,

(G68)

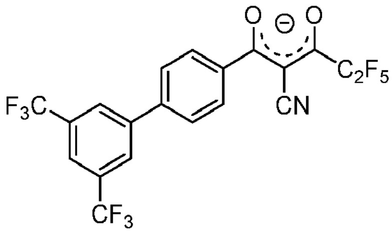

(G69),

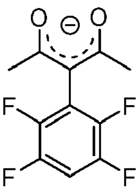

(G70),

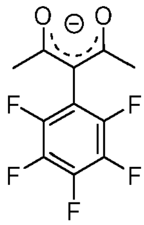

(G71),

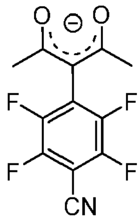

(G72),

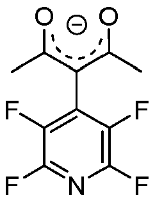

(G73),

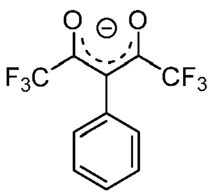

(G74),

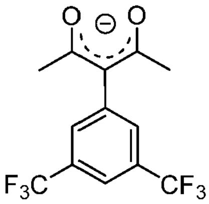

(G75),

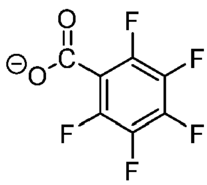

(G76),

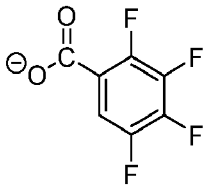

(G77),

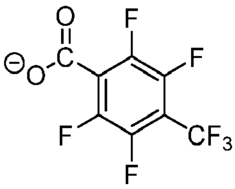

(G78),

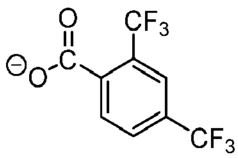

(G79),

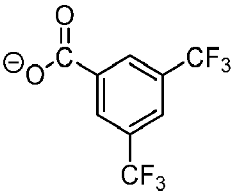

(G80),

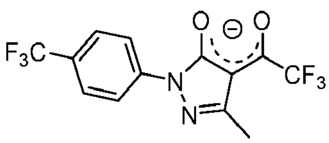

(G81),

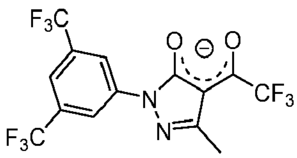

(G82),

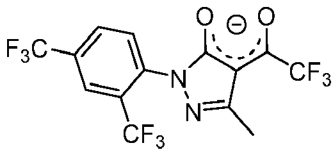 (G83), 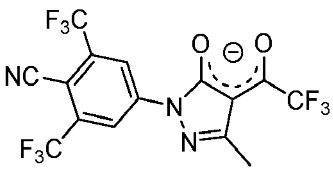 (G84),

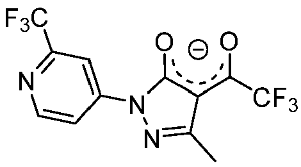 (G85), 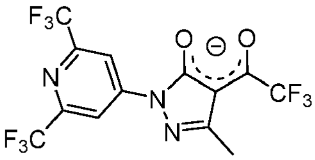 (G86), 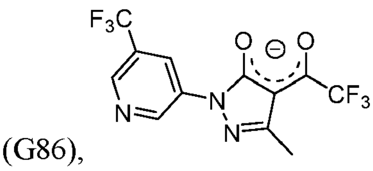 (G87),

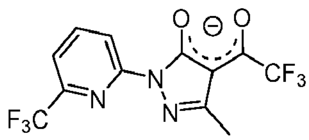 (G88), 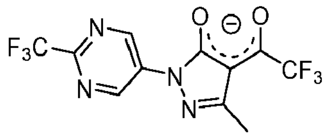 (G89), 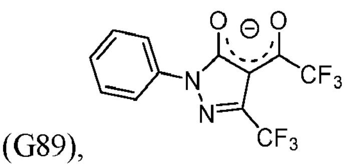 (G90),

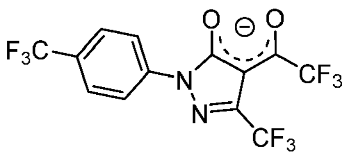 (G91), 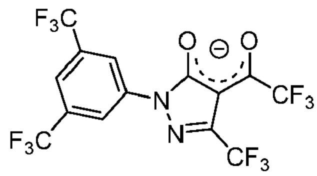 (G92),

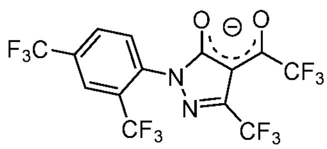 (G93), 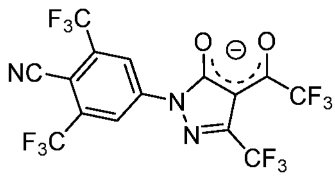 (G94),

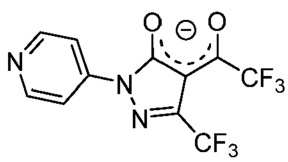 (G95), 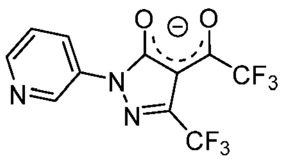 (G96), 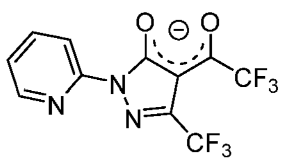 (G97),

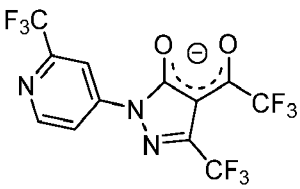 (G98), 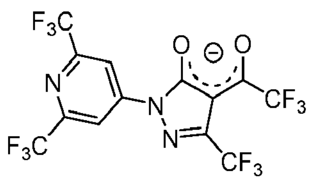 (G99), 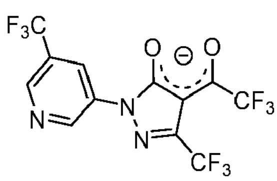 (G100),

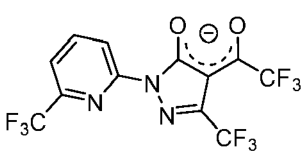 (G101), 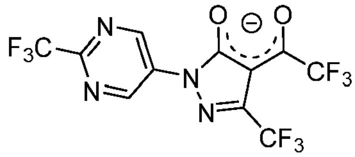 (G102),

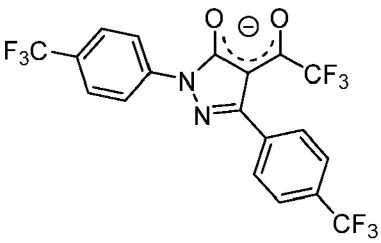 (G103),

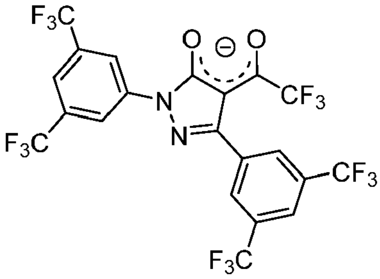 (G104),

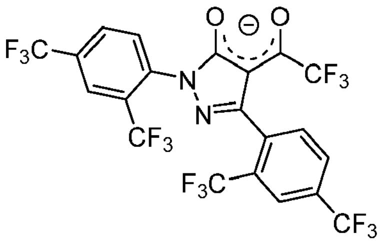 (G105),

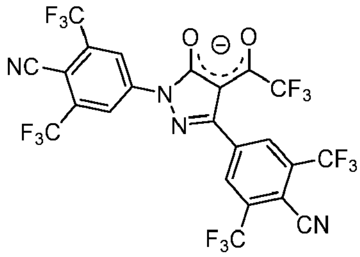 (G106),

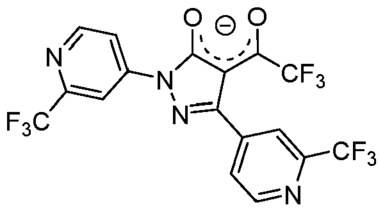 (G107),

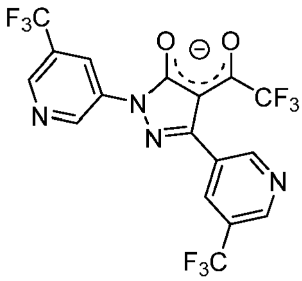 (G108),

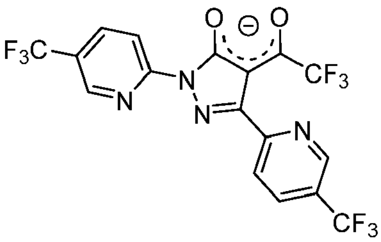 (G109),

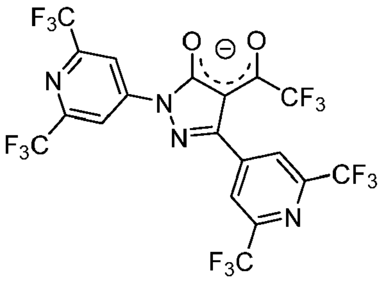 (G110),

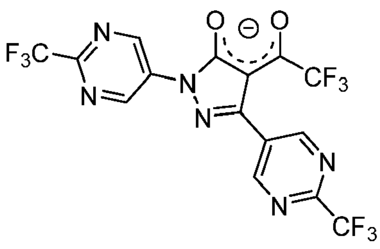 (G111).

According to one embodiment, L of formula (I) and/or (Ia) is selected from (G1) to (G75) and (G81) to (G111), preferably from (G1) to (G69) and (G81) to (G111).

According to one embodiment, L of formula (I) and/or (Ia) is selected from (G1) to (G75), preferably from (G1) to (G69).

According to one embodiment, L of formula (I) and/or (Ia) is selected from (G1) to (G53), preferably (G1) to (G25).

Ligand AL

According to one embodiment of the application AL is selected from the group comprising $H_2O$, $C_2$ to $C_{40}$ mono- or multi-dentate ethers and $C_2$ to $C_{40}$ thioethers, $C_2$ to $C_{40}$ amines, $C_2$ to $C_{40}$ phosphine, $C_2$ to $C_{20}$ alkyl nitrile or $C_2$ to $C_{40}$ aryl nitrile, or a compound according to Formula (AL-I);

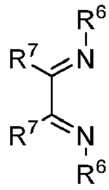
(AL-I),

wherein

$R^6$ and $R^7$ are independently selected from $C_1$ to $C_{20}$ alkyl, $C_1$ to $C_{20}$ heteroalkyl, $C_6$ to $C_{20}$ aryl, heteroaryl with 5 to 20 ring-forming atoms, halogenated or perhalogenated $C_1$ to $C_{20}$ alkyl, halogenated or perhalogenated $C_1$ to $C_{20}$ heteroalkyl, halogenated or perhalogenated $C_6$ to $C_{20}$ aryl, halogenated or perhalogenated heteroaryl with 5 to 20 ring-forming atoms, or at least one $R^6$ and $R^7$ are bridged and form a 5 to 20 member ring, or the two $R^6$ and/or the two $R^7$ are bridged and form a 5 to 40 member ring or form a 5 to 40 member ring comprising an unsubstituted or $C_1$ to $C_{12}$ substituted phenanthroline.

According to one embodiment, wherein the compound of formula (I) and/or (Ia) is selected from: LiTFSI, K TFSI, Cs TFSI, Ag TFSI, $Mg(TFSI)_2$, $Mn(TFSI)_2$, $Sc(TFSI)_3$, $Na[N(SO_2C_4F_9)_2]$, $K[N(SO_2C_4F_9)_2]$, $Mg[N(SO_2{}^{i}C_3F_7)_2]_2$, $Zn[N(SO_2{}^{i}C_3F_7)_2]_2$, $Ag[N(SO_2{}^{i}C_3F_7)_2]$, $Ag[N(SO_2C_3F_7)_2]$, $Ag[N(SO_2C_4F_9)_2]$, $Ag[N(SO_2CF_3)(SO_2C_4F_9)]$, $Cs[N(SO_2C_4F_9)_2]$, $Mg[N(SO_2C_4F_9)_2]_2$, $Ca[N(SO_2C_4F_9)_2]_2$, $Ag[N(SO_2C_4F_9)_2]$, $Cu[N(SO_2{}^{i}C_3F_7)_2]_2$, $Cu[N(SO_2C_3F_7)_2]_2$, $Cu[N(SO_2CF_3)(SO_2C_4F_9)]_2$, $Cu[N(SO_2C_2H_5)(SO_2C_4F_9)]_2$, $Cu[N(SO_2{}^{i}C_3H_7)(SO_2C_4F_9)]_2$, $Cu[N(SO_2{}^{i}C_3F_7)(SO_2C_4F_9)]_2$, $Cu[N(SO_2CH_3)(SO_2C_4F_9)]_2$, $Mg[N(SO_2CF_3)(SO_2C_4F_9)]_2$, $Mn[N(SO_2CF_3)(SO_2C_4F_9)]_2$, $Ag[N(SO_2CH_3)(SO_2C_4F_9)]$,

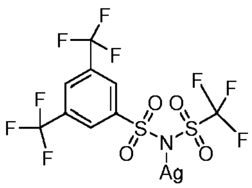
,
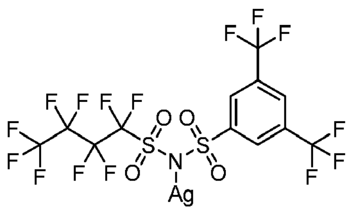
,
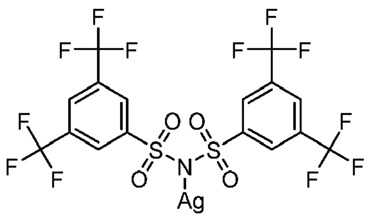
,

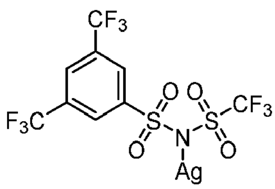
,
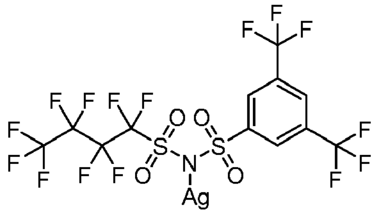
,
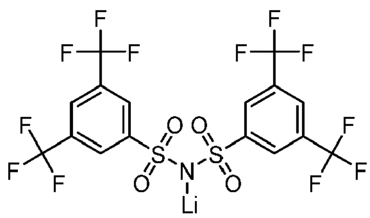

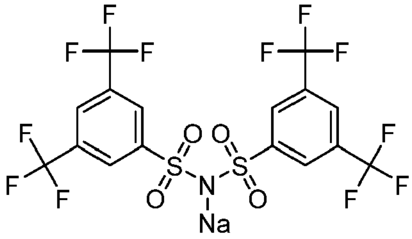,
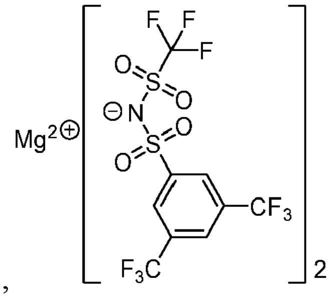,
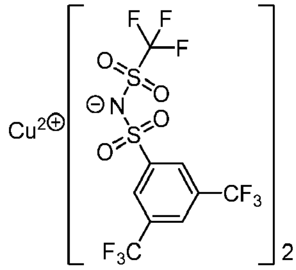,

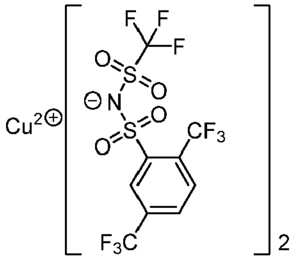,
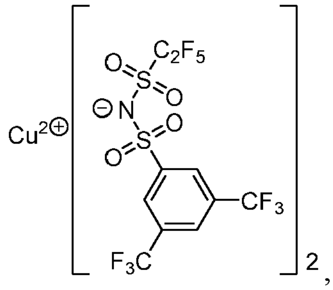,
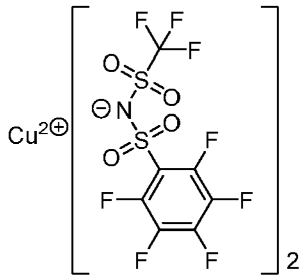,

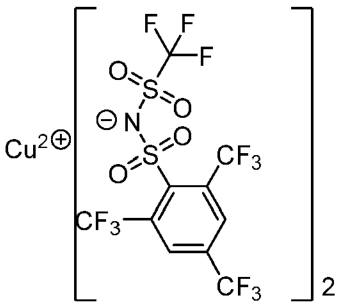,
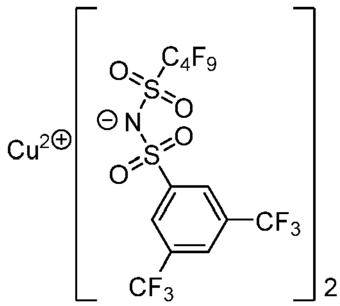,
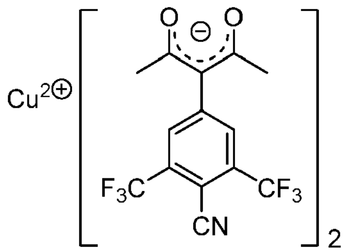,

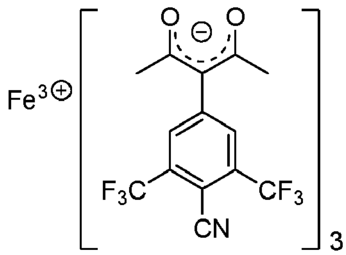,
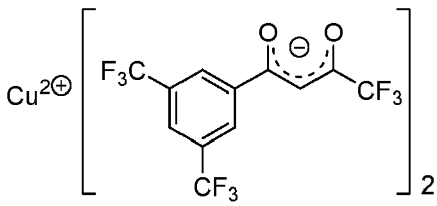,

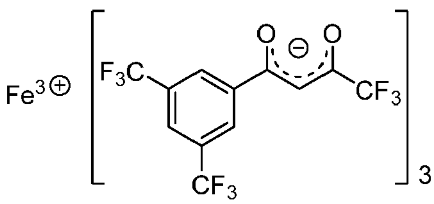,
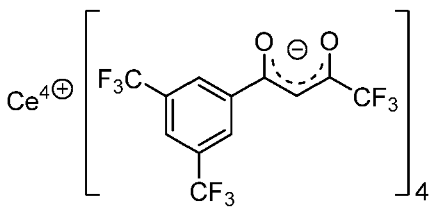,

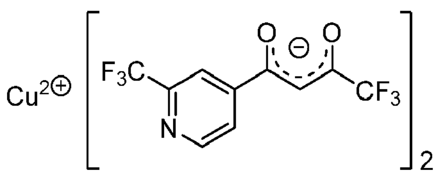,
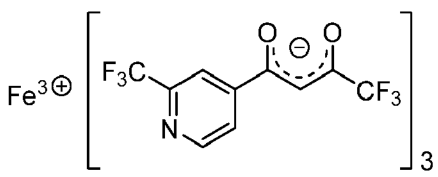,

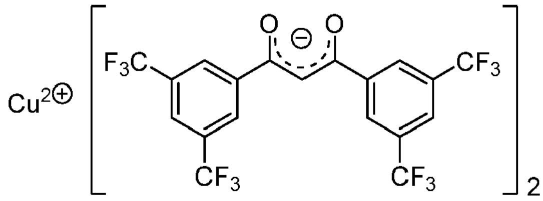, 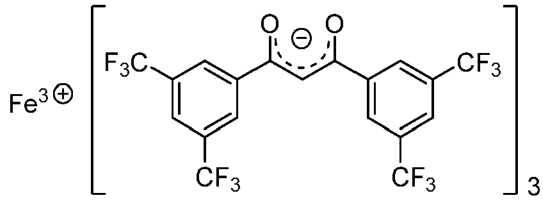,

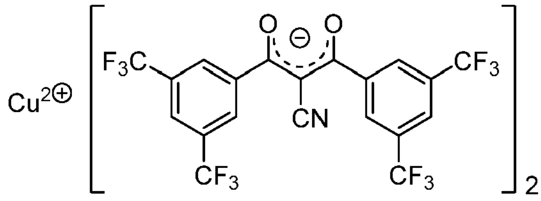, 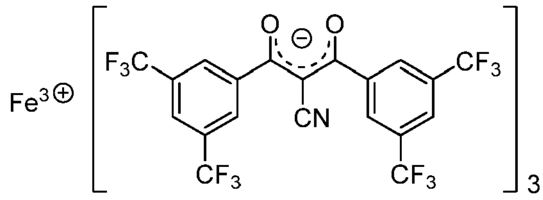,

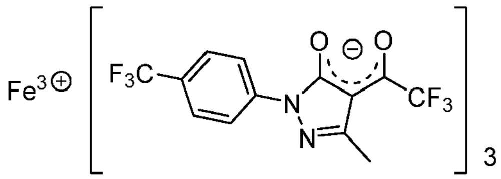, 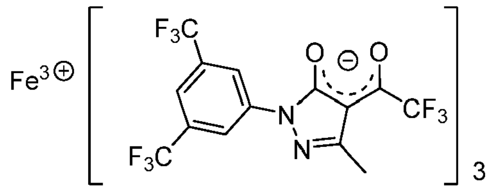,

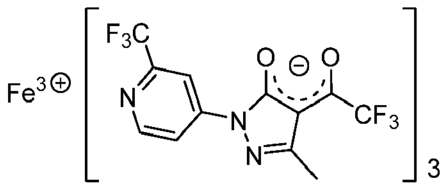, 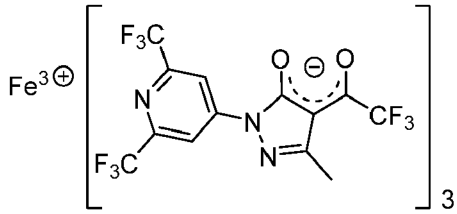,

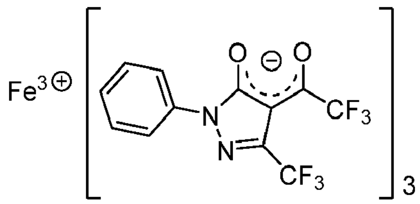, 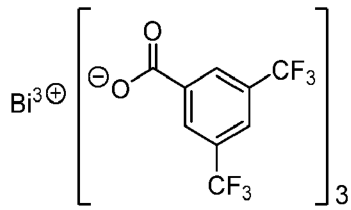,

wherein "i" denotes "iso". For example, "$^{i}C_3F_7$" denotes iso-heptafluoropropyl.

Especially preferred are the following compounds of formula (I) and/or (Ia) in Table 1:

Table 1: Preferred compounds of formula (I) and/or (Ia)

| Name | Chemical formula |
|---|---|
| LiTFSI | $Li[N(SO_2CF_3)_2]$ |
| I-1 | $Na[N(SO_2C_4F_9)_2]$ |
| I-2 | $K[N(SO_2C_4F_9)_2]$ |
| I-3 | $Ag[N(SO_2{}^{i}C_3F_7)_2]$ |

(continued)

| Name | Chemical formula |
|---|---|
| I-4 | 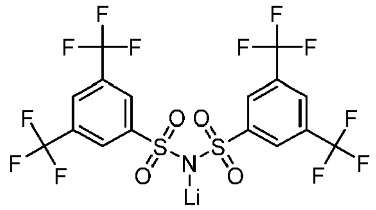 |
| I-5 | 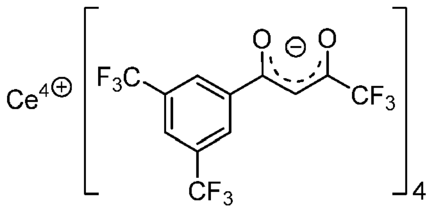 |
| I-6 | 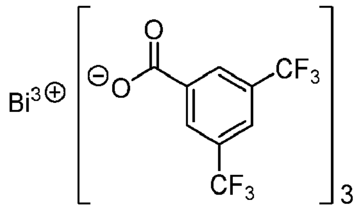 |
| I-7 | 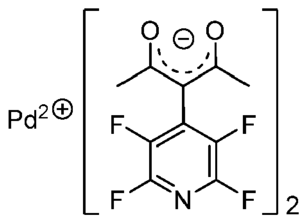 |
| I-8 | $Mg(TFSI)_2$ |

When compound of formula (I) and/or (Ia) is selected from the above list, particularly efficient electron injection from the cathode layer into the electron transport layer may be achieved. Additionally, the compounds of formula (I) and/or (Ia) may have improved thermal properties and a reduced tendency to crystallise. Furthermore, the compounds of formula (I) and/or (Ia) may potentially have reduced health and safety risks compared to the art.

Therefore, compounds of formula (I) and/or (Ia) may be particularly suitable for mass production of organic electronic devices via vacuum thermal evaporation.

Metal

According to one embodiment, the metal of the EIL is selected from an alkali, alkaline earth or rare earth metal, preferably a rare earth metal.

According to one embodiment, the metal of the EIL is Yb.

When the metal is selected accordingly, particularly efficient electron injection from the cathode layer into the electron transport layer may be achieved.

*Electron transport layer (ETL)*

According to an embodiment, the ETL is in direct contact with the EIL.

According to one embodiment of the present invention, the ETL has a thickness of ≥ 5 nm and ≤ 30 nm.

According to one embodiment of the present invention, the ETL is essentially free of a metal organic complex.

According to one embodiment of the present invention, the ETL is essentially free of a metal organic complex free of halogen atoms.

According to one embodiment of the present invention, the ETL is essentially free of quinolate metal complexes, especially according to one embodiment of the present invention, the ETL is essentially free of $Alq_3$ and/or LiQ.

According to an embodiment of the present invention, the ETL is non-emissive.

It is understood that the ETL is not part of an emission layer or EIL.

Compound of formula (II)

According to one embodiment of the present invention, the compound of formula (II) comprises a CN or PO group.

In the compound of Formula (II), the group "Z" is a spacer moiety connecting (if present, that is in case that k > 1) the groups $Ar^2$ and G. In case that the compound of Formula (II) comprises more than one groups ($Z_k$-G) the groups may or may not independently comprise the spacer Z.

In Formula (II), m and n are independently 1 or 2. In Formula (II), m and n may be 1.

In Formula (II), k is independently 0, 1 or 2. In Formula (II), k may be independently 1 or 2.

$Ar^2$ may be independently selected from the group consisting of $C_2$ to $C_{39}$ heteroaryl and $C_6$ to $C_{54}$ aryl, optionally $C_2$ to $C_{36}$ heteroaryl and $C_6$ to $C_{48}$ aryl, optionally $C_3$ to $C_{30}$ heteroaryl and $C_6$ to $C_{42}$ aryl, optionally $C_3$ to $C_{27}$ heteroaryl and $C_6$ to $C_{36}$ aryl, optionally $C_3$ to $C_{24}$ heteroaryl and $C_6$ to $C_{30}$ aryl, and optionally $C_3$ to $C_{21}$ heteroaryl and $C_6$ to $C_{24}$ aryl.

$Ar^2$ may be independently selected from the group consisting of $C_2$ to $C_{39}$ N-containing heteroaryl and $C_6$ to $C_{54}$ aryl, optionally $C_2$ to $C_{36}$ N-containing heteroaryl and $C_6$ to $C_{48}$ aryl, optionally $C_3$ to $C_{30}$ N-containing heteroaryl and $C_6$ to $C_{42}$ aryl, optionally $C_3$ to $C_{27}$ N-containing heteroaryl and $C_6$ to $C_{36}$ aryl, optionally $C_3$ to $C_{24}$ N-containing heteroaryl and $C_6$ to $C_{30}$ aryl, and optionally $C_3$ to $C_{21}$ N-containing heteroaryl and $C_6$ to $C_{24}$ aryl. In this regard, it may be provided that a respective N-containing heteroaryl comprises one or more N-atoms as the only heteroatom(s).

$Ar^2$ may comprise at least two annelated 5- or 6-membered rings.

$Ar^2$ may be independently selected from the group consisting of pyridinyl, triazinyl, 1,2-diazinyl, 1,3-diazinyl, 1,4-diazinyl, quinazolinyl, benzoquinazolinyl, benzimidazolyl, quinolinyl, benzoquinolinyl benzoacridinyl, dibenzoacridinyl, fluoranthenyl, anthracenyl, naphthyl, triphenylenyl, phenathrolinyl, and dinaphthofuranyl which may be substituted or unsubstituted, respectively.

$Ar^2$ may be independently selected from the group consisting of 1,3-diazinyl, 1,4-diazinyl, anthracenyl, triazinyl, phenathrolinyl, triphenylenyl, pyridinyl.

Wherein if n is 2, $Ar^2$ may be selected independently from one of the following groups (A1) to (A6),

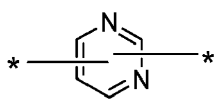 (A1), 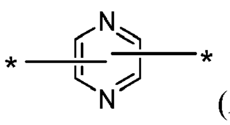 (A2), 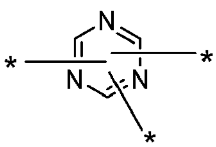 (A3), 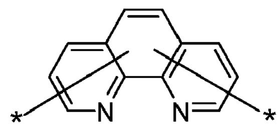 (A4),

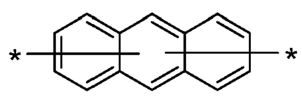 (A5), 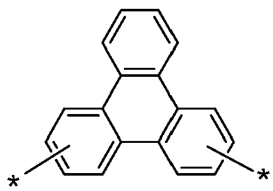 (A6);

if n is 1, $Ar^2$ may be selected independently from one of the following groups (A7) to (A16),

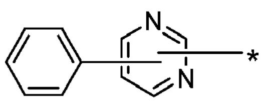 (A7), 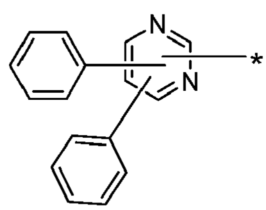 (A8), 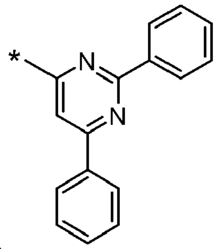 (A9),

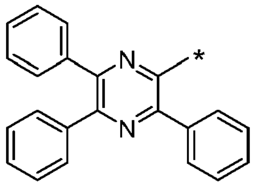 (A10), 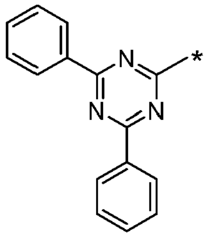 (A11), 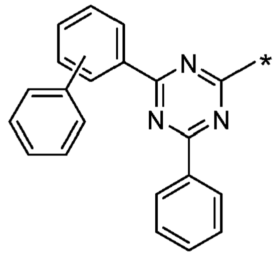 (A12),

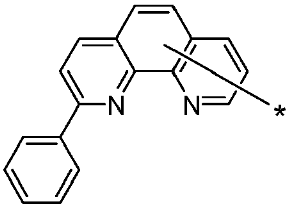 (A13), 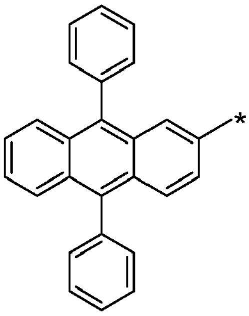 (A14), 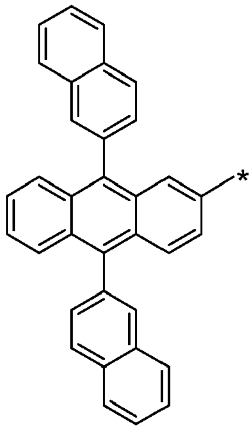 (A15),

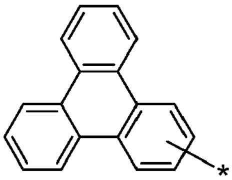 (A16);

wherein the asterisk symbol "*" represents the binding position for binding the $Ar^2$ to Z, respectively.

In case that $Ar^2$ is substituted, each substituent on $Ar^2$ may be independently selected from the group consisting of phenyl, naphthyl, optionally β-naphthyl, pyridinyl and biphenyl-yl which may be substituted or unsubstituted, respectively.

In case that $Ar^2$ is substituted, each substituent on $Ar^2$ may be independently selected from the group consisting of phenyl, pyridinyl and biphenyl-yl, optionally para-biphenyl-yl.

Z may be independently selected from $C_6$ to $C_{24}$ aryl, alternatively $C_6$ to $C_{18}$ aryl, alternatively $C_6$ to $C_{12}$ aryl, which may be substituted or unsubstituted.

Z may be selected from the group consisting of phenylene, naphthylene, phenylene-naphthylene, biphenylene and terphenylene which may be substituted or unsubstituted, respectively.

Z may be selected independently from one of the following groups (Z1) to (Z7),

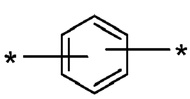 (Z1), 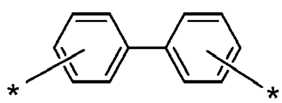 (Z2), 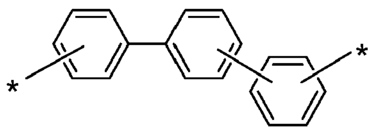 (Z3),

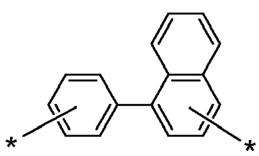 (Z4), 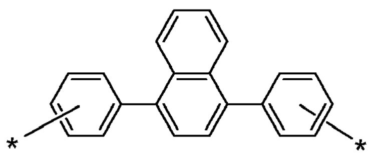 (Z5),

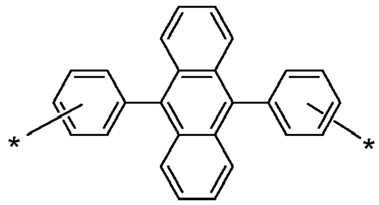 (Z6), 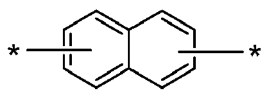 (Z7),

wherein the asterisk symbol "*" represents the binding position for binding to $Ar^2$ and G, respectively.

In case that Z is substituted, each substituent on Z may be independently selected from the group consisting of phenyl and $C_1$ to $C_4$ alkyl.

G is chosen so that the dipole moment, computed by the TURBOMOLE V6.5 program package using hybrid functional B3LYP and Gaussian 6-31G* basis set, of a compound G-phenyl is ≥ 1 D and ≤ 7 D. The unit for the dipole moment "Debye" is abbreviated with the symbol "D". The inventors have found that it is advantageous if the compound of Formula (II) comprises a group having a certain polarity, that is a specific dipole moment within the above range or the ranges mentioned below. It was further found that it is still advantageous that the compound of Formula (II) comprises such a polar group (first polar group) if the compound of Formula (II) comprises, in addition, a further polar group (second polar group) which is suitable to balance the dipole moment of the first polar group in a way that the total dipole moment of the compound of Formula (II) is low, for example, in case that the compound is a symmetrical molecule comprising a first polar group and a second polar group which are the same, the dipole moment could be 0 Debye. Therefore, the compound of Formula (II) cannot be characterized be referring to the total dipole moment of the compound. As a consequence, reference is made instead to an artificial compound comprising the polar group "G" and an unpolar group "phenyl". In this regards, the dipole moment $|\vec{\mu}|$ of a compound containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $r_i$ are the partial charge and position of atom i in the molecule. The dipole moment is determined by a semi-empirical molecular orbital method. The geometries of the molecular structures are optimized using the hybrid functional B3LYP with the 6-31G* basis set in the gas phase as implemented in the program package TURBOMOLE V6.5 (TURBOMOLE GmbH, Litzenhardtstrasse 19, 76135 Karlsruhe, Germany). If more than one conformation is viable, the conformation with the lowest total energy is selected to determine the bond lengths of the molecules. In this regard, the entire moiety G encompasses all possible substituents which may be comprised.

G may be selected so that the dipole moment of a compound G-phenyl is > 1 D; optionally ≥ 2 D; optionally ≥ 2.5 D, optionally ≥ 2.5 D, optionally ≥ 3 D, and optionally ≥ 3.5 D. G may be chosen so that the dipole moment of a compound G-phenyl is ≤ 7 D, optionally ≤ 6.5 D, optionally ≤ 6 D, optionally ≤ 5.5 D, optionally ≤ 5 D. If more than one conformational isomer of the compound G-phenyl is viable then the average value of the dipole moments of the conformational isomers of G-phenyl is selected to be in this range. Conformational isomerism is a form of stereoisomerism in which the isomers can be interconverted just by rotations about formally single bonds.

By selecting the G such that the dipole moment of a compound G-phenyl lies in the above range it is provided that the electron injection from the adjacent, distinct electron injection layer (EIL) is improved and operating voltage of the OLED device is decreased and the color-corrected cd/A efficiency of the OLED device is increased.

Exemplary compounds "G-phenyl" are listed in the following Table 2, wherein the moiety

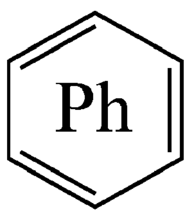

in the respective compound specifies the "phenyl" part in "G-phenyl"

Table 2:

| | Structure of G-phenyl | HOMO [eV] | LUMO [eV] | Dipole moment [D] |
|---|---|---|---|---|
| G-phenyl-1 | 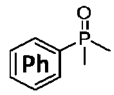 | -6.88 | -0.62 | **4.16** |
| G-phenyl-2 | 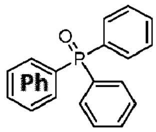 | -6.74 | -0.86 | **4.19** |
| G-phenyl-3 | 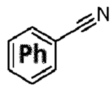 | -8.97 | 1.00 | **4.56** |
| G-phenyl-4 | 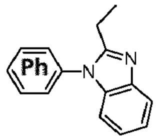 | -5.82 | -0.62 | **3.97** |
| G-phenyl-5 | 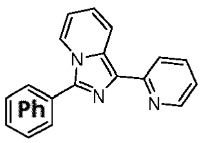 | -5.04 | -1.18 | **3.86** |
| G-phenyl-6 | 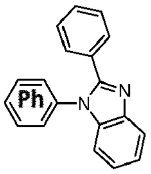 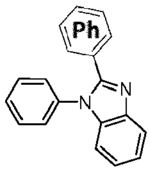 | -5.70 | -1.02 | **3.70** |
| G-phenyl-7 | 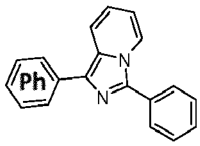 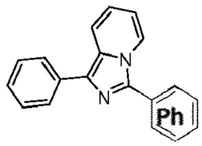 | -4.92 | -1.11 | **3.11** |
| G-phenyl-8 | 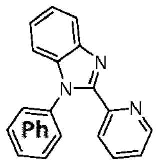 | -5.86 | -1.19 | **5.14** |
| G-phenyl-9 | 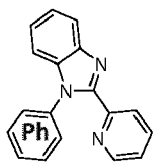 | -5.76 | -1.33 | **2.61** |

(continued)

| | Structure of G-phenyl | HOMO [eV] | LUMO [eV] | Dipole moment [D] |
|---|---|---|---|---|
| G-phenyl-10 | 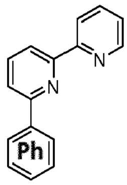 | -5.96 | -1.35 | **2.69** |
| G-phenyl-11 | 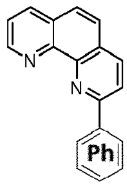 | -5.83 | -1.59 | **2.67** |
| G-phenyl-12 | 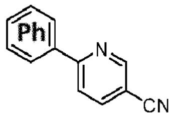 | -6.59 | -2.08 | **4.79** |
| G-phenyl-13 | 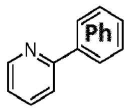 | -6.12 | -1.13 | **1.71** |
| G-phenyl-14 | 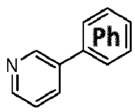 | -6.32 | -0.98 | **2.31** |
| G-phenyl-15 | 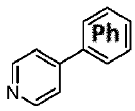 | -6.57 | -1.19 | **2.75** |
| G-phenyl-16 | 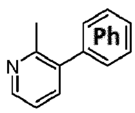 | -6.28 | -0.77 | **2.00** |
| G-phenyl-17 | 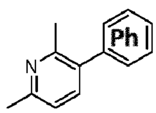 | -6.12 | -0.69 | **1.50** |
| G-phenyl-18 | 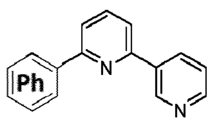 | -6.10 | -1.41 | **3.51** |
| G-phenyl-19 | 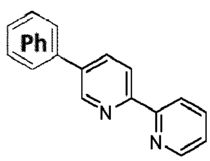 | -6.10 | -1.38 | **2.98** |

(continued)

| | Structure of G-phenyl | HOMO [eV] | LUMO [eV] | Dipole moment [D] |
|---|---|---|---|---|
| G-phenyl-20 | 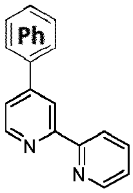 | -6.47 | -1.31 | **3.46** |
| G-phenyl-21 | 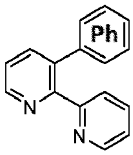 | -6.19 | -1.03 | **3.02** |
| G-phenyl-22 | 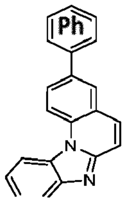 | -5.54 | -1.58 | **3.49** |
| G-phenyl-23 | 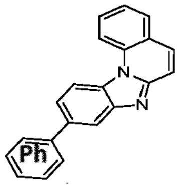 | -5.60 | -1.61 | **3.39** |
| G-phenyl-24 | 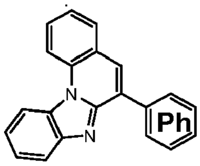 | -5.48 | -1.67 | **2.76** |
| G-phenyl-25 | 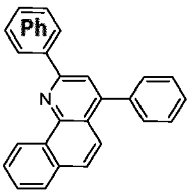 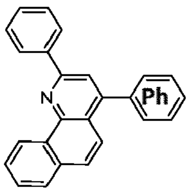 | -5.63 | -1.56 | **1.84** |
| G-phenyl-26 | 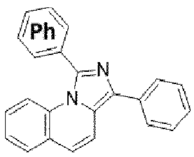 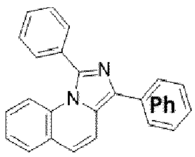 | -5.02 | -1.39 | **2.96** |
| G-phenyl-27 | 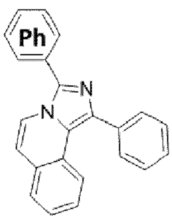 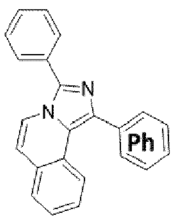 | -5.08 | -1.13 | **2.70** |

(continued)

| | Structure of G-phenyl | HOMO [eV] | LUMO [eV] | Dipole moment [D] |
|---|---|---|---|---|
| G-phenyl-28 | 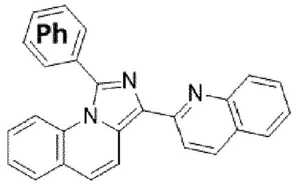 | -5.07 | -1.58 | **2.29** |
| G-phenyl-29 | 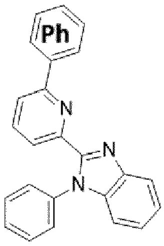 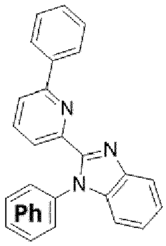 | -5.81 | -1.19 | **4.61** |
| G-phenyl-30 | 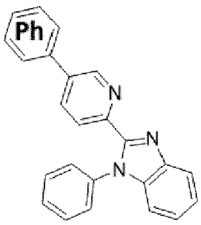 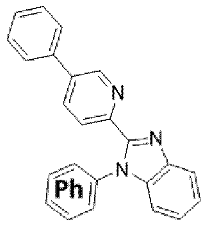 | -5.78 | -1.42 | **5.20** |
| G-phenyl-31 | 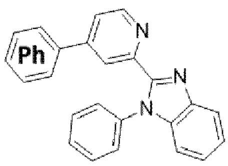 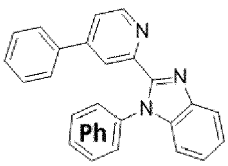 | -5.84 | -1.38 | **5.63** |
| G-phenyl-32 | 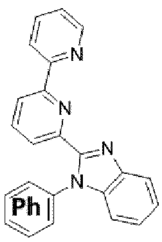 | -5.83 | -1.35 | **3.37** |
| G-phenyl-33 | 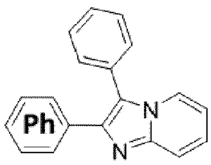 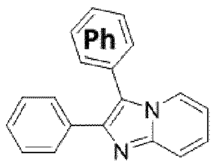 | -5.37 | -0.98 | **3.32** |
| G-phenyl-34 | 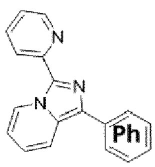 | -4.94 | -1.15 | **1.81** |

(continued)

| | Structure of G-phenyl | HOMO [eV] | LUMO [eV] | Dipole moment [D] |
|---|---|---|---|---|
| G-phenyl-3 5 | 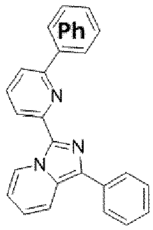 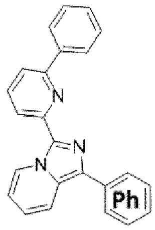 | -4.94 | -1.16 | **2.12** |
| G-phenyl-36 | 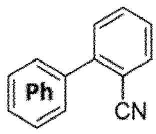 | -6.52 | -1.47 | **4.17** |
| G-phenyl-37 | 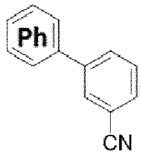 | -6.56 | -1.46 | **4.85** |
| G-phenyl-3 8 | 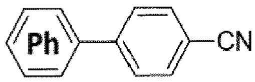 | -6.53 | -1.67 | **5.27** |
| G-phenyl-39 | 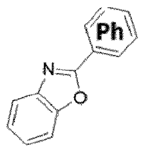 | -6.00 | -1.43 | **1.14** |
| G-phenyl-40 | 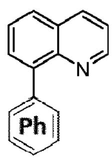 | -5.84 | -1.47 | **1.94** |
| G-phenyl-41 | 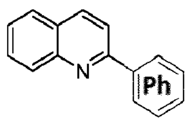 | -5.97 | -1.56 | **1.53** |
| G-phenyl-42 | 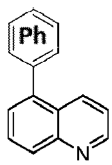 | -6.01 | -1.42 | **2.31** |
| G-phenyl-43 | 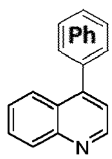 | -6.09 | -1.47 | **2.57** |

(continued)

| | Structure of G-phenyl | HOMO [eV] | LUMO [eV] | Dipole moment [D] |
|---|---|---|---|---|
| G-phenyl-44 | 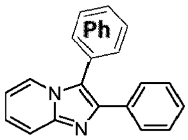 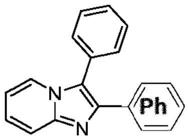 | -5.37 | -0.98 | **3.32** |
| G-phenyl-45 | 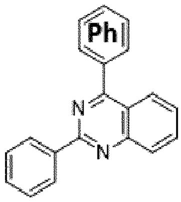 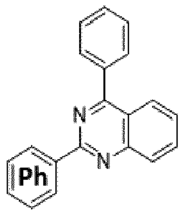 | -6.00 | -1.88 | **2.46** |
| G-phenyl-46 | 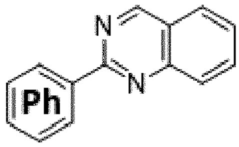 | -6.12 | -1.82 | **2.22** |
| G-phenyl-47 | 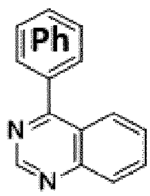 | -6.36 | -1.87 | **3.04** |
| G-phenyl-48 | 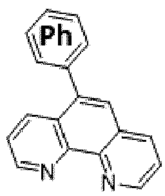 | -6.03 | -1.46 | **3.58** |
| G-phenyl-49 | 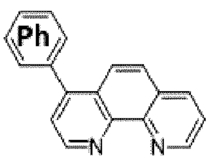 | -6.09 | -1.46 | **3.67** |
| G-phenyl-50 | 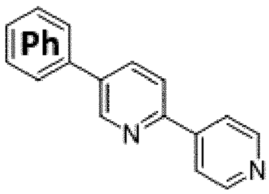 | -6.17 | -1.85 | **4.56** |
| G-phenyl-51 | 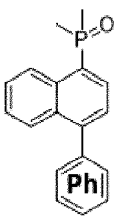 | -5.84 | -1.41 | **4.28** |

(continued)

| | Structure of G-phenyl | HOMO [eV] | LUMO [eV] | Dipole moment [D] |
|---|---|---|---|---|
| G-phenyl-52 | 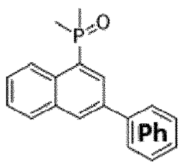 | -5.81 | -1.40 | **3.98** |
| G-phenyl- 53 | 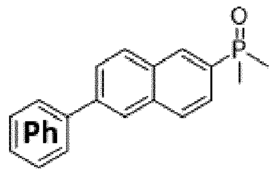 | -5.84 | -1.61 | **4.50** |
| G-phenyl-54 | 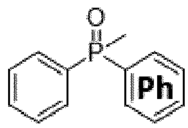 | -6.85 | -0.85 | **4.00** |
| G-phenyl-55 | 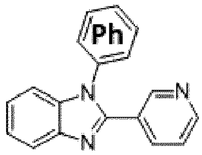 | -5.88 | -1.27 | **2.59** |
| G-phenyl-56 | 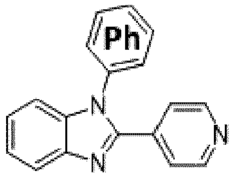 | -6.02 | -1.48 | **4.35** |

G may be selected from the group consisting of dialkylphosphine oxide, diarylphosphine oxide, alkylarylphosphine oxide, diheteroarylphosphine oxide, arylheteroarylphosphine oxide, nitrile, benzonitrile, and $C_2$ to $C_{17}$ heteroaryl; wherein the respective G may include one or more substituents attached to the group, wherein the one or more substituents are selected from the group consisting of phenyl, methyl, ethyl, and pyridyl.

G may be selected independently from the group consisting of dimethylphosphine oxide, diphenylphosphine oxide, nitrile, benzonitrile, di-hydro-benzoimidazolone-yl, diphenyl-propane-yl, imidazolyl, phenylbenzoimidazolyl, ethylbenzoimidazolyl phenylbenzoquinolinyl, phenylbenzoimidazoquinolinyl, pyridinyl, bipyridinyl, picolinyl, lutidenyl, pyridazinyl, pyrimidinyl, pyrazinyl, triphenyl-pyrazinyl, benzoquinolinyl, phenanthrolinyl, phenylphenanthrolinyl, quinazolinyl, benzoxazolyl, benzimidazolyl, pyridinyl-imidazopyridinyl.

According to a preferred embodiment, G may be selected from formula (G1) to (G10),

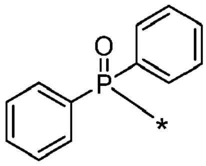 (G1), 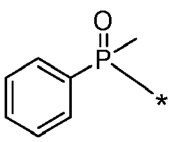 (G2), 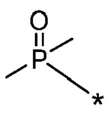 (G3), 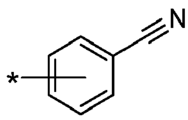 (G4), 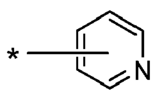 (G5),

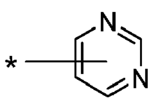 (G6), 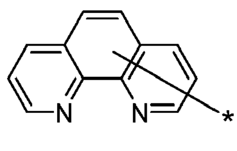 (G7), 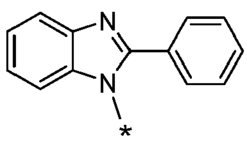 (G8), 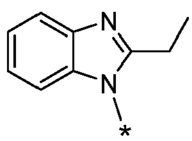 (G9),

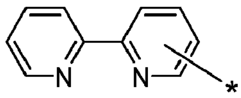
(G10),

wherein the asterisk symbol "*" represents the binding position; preferably (G1) to (G5).

The compound of Formula (II) may be selected from the compounds B-1 to B-18 of the following Table 3:

Table 3: Selected chemical formulae of compounds of formula (II) with their HOMO, LUMO and dipole moment

| Name | Chemical formula | HOMO [eV] | LUMO [eV] | Dipole moment [D] |
|---|---|---|---|---|
| B-1 | 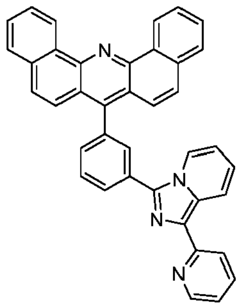 | -5.03 | -1.81 | 0.98 |
| B-2 | 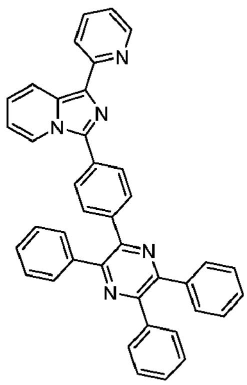 | -4.94 | -1.61 | 1.77 |
| B-3 | 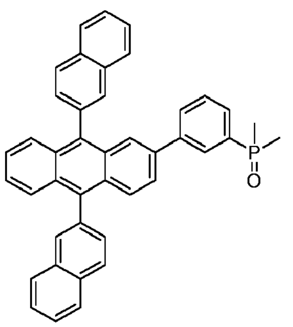 | -5.11 | -1.75 | 3.78 |

(continued)

| Name | Chemical formula | HOMO [eV] | LUMO [eV] | Dipole moment [D] |
|---|---|---|---|---|
| B-4 | 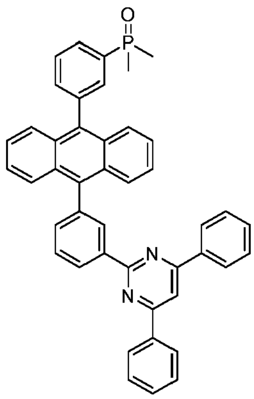 | -5.20 | -1.75 | 6.15 |
| B-5 | 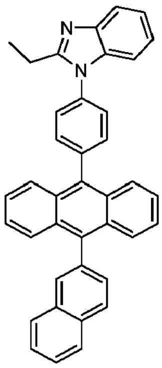 | -5.26 | -1.81 | 4.32 |
| B-6 | 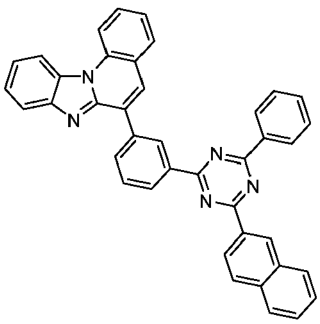 | -5.56 | -1.85 | 3.39 |
| B-7 | 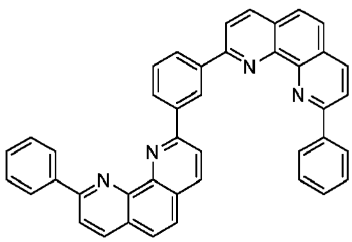 | -5.62 | -1.75 | 2.66 |

(continued)

| Name | Chemical formula | HOMO [eV] | LUMO [eV] | Dipole moment [D] |
|---|---|---|---|---|
| B-8 | 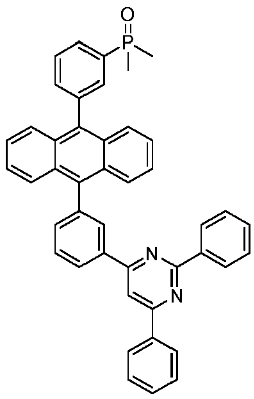 | -5.34 | -1.86 | 2.59 |
| B-9 | 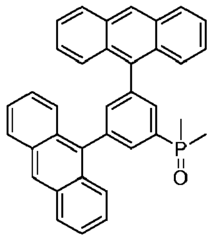 | -5.19 | -1.81 | 4.11 |
| B-10 | 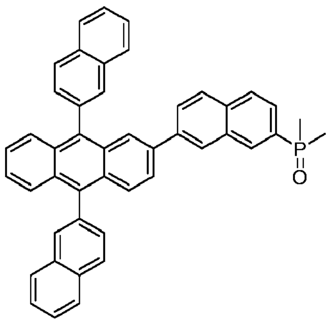 | -5.11 | -1.80 | 3.84 |
| B-11 | 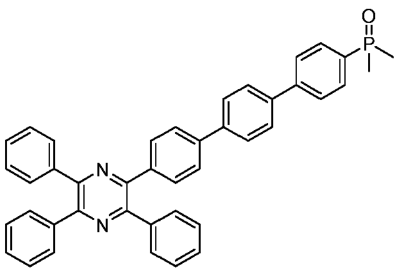 | -5.69 | -1.67 | 4.37 |

(continued)

| Name | Chemical formula | HOMO [eV] | LUMO [eV] | Dipole moment [D] |
|---|---|---|---|---|
| B-12 | 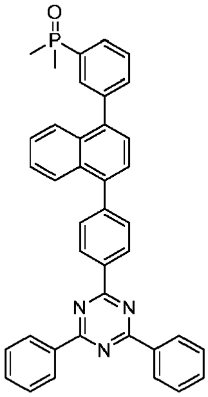 | -5.76 | -1.97 | 4.27 |
| B-13 | 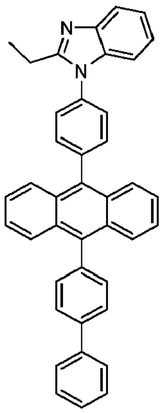 | -5.29 | -1.80 | 4.46 |
| B-14 | 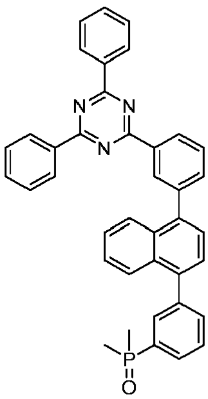 | -5.73 | -1.90 | 4.49 |
| B-15 | 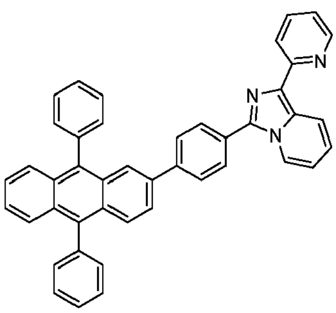 | -4.86 | -1.77 | 2.03 |

(continued)

| Name | Chemical formula | HOMO [eV] | LUMO [eV] | Dipole moment [D] |
|---|---|---|---|---|
| B-16 | 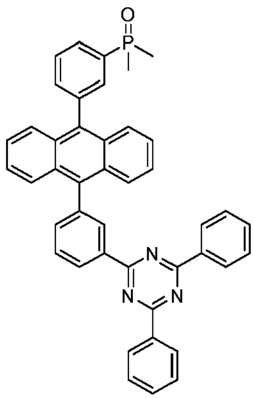 | -5.28 | -1.90 | 4.47 |
| B-17 | 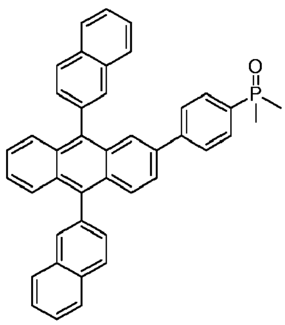 | -5.17 | -1.84 | 4.22 |
| B-18 | 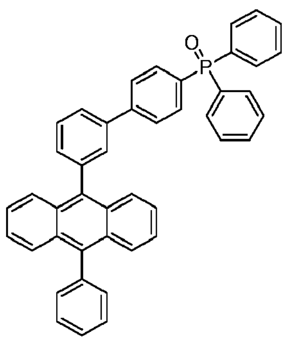 | -5.16 | -1.67 | 4.13 |

In an embodiment the LUMO energy level of the compound of formula (II) in the absolute scale taking vacuum energy level as zero, computed by the TURBOMOLE V6.5 program package using hybrid functional B3LYP and Gaussian 6-31G* basis set, is in the range from -2.30 eV to - 1.20 eV, preferably from -2.10 eV to -1.28 eV.
In an embodiment the compound of formula (II) comprises one polar group "G".

Compound of formula (III)

According to one embodiment of the present invention, the ETL further comprises a compound of formula (III): Formula (III): An organic compound having 8 to 13 aromatic or heteroaromatic rings.
According to one embodiment of the present invention, the compound of formula (III) comprises 8 to 13 aromatic or heteroaromatic rings, optionally 8 t0 11 aromatic or heteroaromatic rings, optionally 9 to 11 aromatic or heteroaromatic rings, and optionally 9 aromatic or heteroaromatic rings, wherein one or more of the aromatic or heteroaromatic rings may be substituted with $C_1$ to $C_4$ alkyl. In this regard, an aromatic, respectively heteroaromatic ring is a single aromatic ring, for example a 6-membered aromatic ring such as phenyl, a 6-membered heteroaromatic ring such as pyridyl, a 5-membered heteroaromatic ring such as pyrrolyl etc. In a system of condensed (hetero)aromatic rings, each ring is considered as a single ring in this regard. For example, naphthalene comprises two aromatic rings.

According to one embodiment of the present invention, the compound of formula (III) comprises at least one heteroaromatic ring, optionally 1 to 5 heteroaromatic rings, optionally 1 to 4 heteroaromatic rings, optionally 1 to 3 heteroaromatic rings, and optionally 1 or 2 heteroaromatic rings.

The aromatic or heteroaromatic rings of the compound of formula (III) may be 6-membered rings.

The heteroaromatic rings of the compound of formula (III) may be a N-containing heteroaromatic ring, optionally all of the heteroaromatic rings are N-containing heteroaromatic rings, optionally all of the heteroaromatic rings heteroaromatic rings contain N as the only type of heteroatom.

The compound of formula (III) may comprise at least one 6-membered heteroaromatic ring containing one to three N-atoms in each heteroaromatic ring, optionally one to three 6-membered heteroaromatic rings containing one to three N-atoms in each heteroaromatic ring, respectively.

The at least one 6-membered heteroaromatic ring comprised in the compound of formula (III) may be an azine. The at least one 6-membered heteroaromatic ring comprised in the compound of formula (III) may be triazine, diazine, pyrazine.

If the compound of formula (III) comprises two or more heteroaromatic rings, the heteroaromatic rings may be separated from each other by at least one aromatic ring which is free of a heteroatom.

In an embodiment, the heteroatoms in the heteroaromatic rings of compound of formula (III) are bound into the molecular structure of compound of formula (III) by at least one double bond.

The molecular dipole moment, computed by the TURBOMOLE V6.5 program package using hybrid functional B3LYP and Gaussian 6-31G* basis set, of the compound of formula (III) may be ≥ 0 D and ≤ 4 D; alternatively ≥ 0.1 D and ≤ 3.9 D; alternatively ≥ 0.2 D and ≤ 3.7 D; alternatively ≥ 0.3 D and ≤ 3.5 D.

By choosing compound of formula (III) according to these embodiments it is provided that the mobility of the electron transport layer is further improved and operating voltage of the OLED device is decreased and the color-corrected cd/A efficiency of the OLED device is increased.

In an embodiment, the compound of formula (III) is not a compound of formula (II).

According to one embodiment of the present invention, the compound of formula (III) is from the compounds C-1 to C-6 of the following Table 4.

Table 4: Selected chemical formulae of compounds of formula (III) with their HOMO, LUMO and dipole moment

| Name | Chemical formula | HOMO [eV] | LUMO [eV] | Dipole moment [D] |
|---|---|---|---|---|
| C-1 | 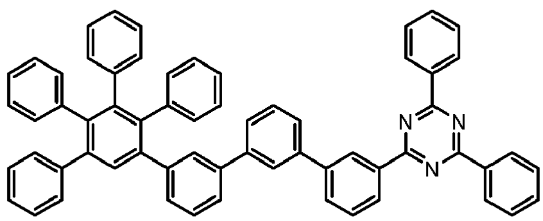 | -5.72 | -1.82 | 0.30 |
| C-2 | 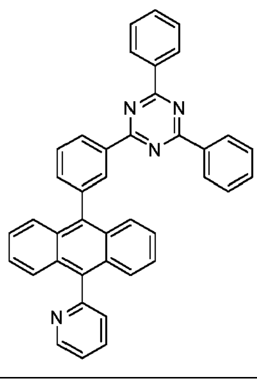 | -5.11 | -1.83 | 1.98 |

(continued)

| Name | Chemical formula | HOMO [eV] | LUMO [eV] | Dipole moment [D] |
|---|---|---|---|---|
| C-3 | 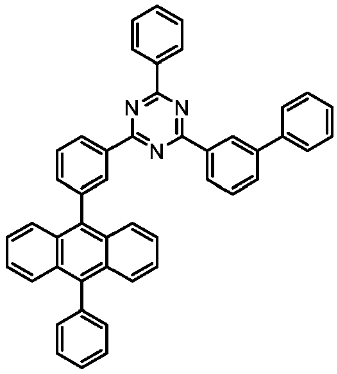 | -5.19 | -1.84 | 0.37 |
| C-4 | 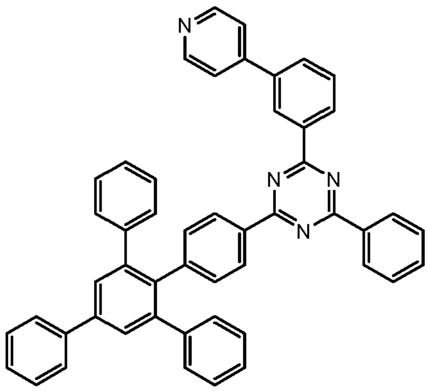 | -5.87 | -1.94 | 3.24 |
| C-5 | 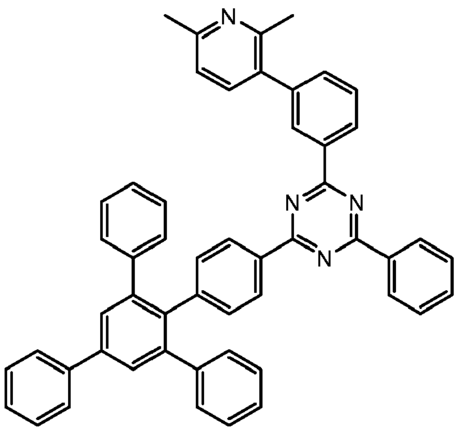 | -5.83 | -1.86 | 1.61 |
| C-6 | 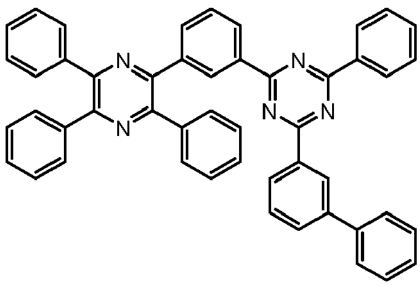 | -5.67 | -1.85 | 0.40 |

In case that the electron transport layer comprises both the compound of formula (II) and compound of formula (III), the weight ratio of compound of formula (II) to compound of formula (III) may be 1:99 to 99:1, alternatively 10:90 to

60:40, alternatively 20:80 to 50:50, alternatively 25:75 to 40:60, alternatively about 30:70.

In an embodiment the LUMO energy level of the compound of formula (III) in the absolute scale taking vacuum energy level as zero, computed by the TURBOMOLE V6.5 program package using hybrid functional B3LYP and Gaussian 6-31G* basis set, is in the range from -2.00 eV to - 1.70 eV, preferably from -1.95 eV to -1.80 eV.

In an embodiment the compound of formula (III) comprises one nitrogen-containing six-membered ring.

In another embodiment the compound of formula (III) comprises two nitrogen-containing six-membered rings.

According to a preferred embodiment of the present invention, the electron transport layer comprises a compound of formula (II) and a compound of formula (III), wherein the compound of formula (II) comprises a triazine group and a phosphine oxide group and the compound of formula (III) comprises a triazine group.

*Cathode layer*

The thickness of the cathode layer may be in the range from about 5 nm to about 100 nm, preferably in the range from about 10 nm to about 50 nm, more preferred in the range of about 10 to about 20 nm.

According to one embodiment, the cathode layer comprises ≥ 80 vol.-% Ag, more preferred ≥ 85 vol.-% Ag.

According to one embodiment, the cathode layer comprises ≥ 50 vol.-% Ag and ≤ 50 vol.-% Mg, more preferred ≥ 80 vol.-% Ag and ≤ 20 vol.-% Mg, even more preferred ≥ 85 vol.-% Ag and ≤ 25 vol.-% Mg.

When the cathode layer is selected in this range, the cathode layer may be transparent to the visible light emission spectrum.

According to a preferred embodiment of the invention, light is emitted through the cathode layer.

It is to be understood that the cathode layer is not part of an electron injection layer or the electron transport layer.

Further layers

In accordance with the invention, the organic electroluminescent device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and a third anode sub-layer comprising or consisting of transparent conductive oxide. Preferably the first anode sub-layer may comprise or consists of Ag, the second anode-sublayer may comprise or consists of ITO or IZO and the third anode sub-layer may comprises or consists of ITO or IZO.

Preferably, the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive

oxide having a thickness of 3 to 20 nm.

*Hole injection layer*

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 30 nm, and for example, from about 1 nm to about 15 nm. When the thickness of the HIL is within this range, the HIL may have excellent hole injecting characteristics, without a substantial penalty in driving voltage.

According to an embodiment of the electronic device, wherein the hole injection layer is non-emissive.

It is to be understood that the hole injection layer is not part of the anode layer.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

According to one embodiment of the present invention, the organic electroluminescent device further comprises a hole injection layer, wherein the hole injection layer is arranged between the anode layer and the first emission layer, and wherein the hole injection layer comprises a compound of formula (I) and/or (Ia).

According to an embodiment, the compound of formula (I) and/or (Ia) in the HIL and in the EIL may be selected the same.

According to one embodiment, the organic electroluminescent device further comprises a hole injection layer, wherein the hole injection layer is arranged between the anode layer and the first emission layer, wherein the hole injection layer comprises a p-type dopant. The p-type dopant concentrations can be selected from 1 to 20 wt.-%, more preferably from 3 wt.-% to 10 wt.-%.

In one embodiment, the p-type dopant is selected from a radialene compound and/or a quinodimethane compound, wherein the radialene compound and/or quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

Preferably the p-type dopant is selected from a radialene compound. In one embodiment, the radialene compound may have formula (XX) and/or the quinodimethane compound may have formula (XXIa) or (XXIb):

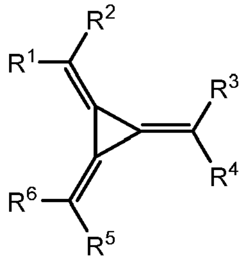 (XX), 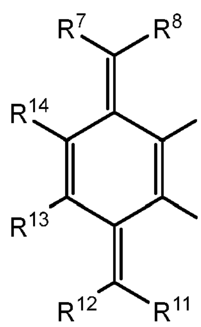 (XXIa),

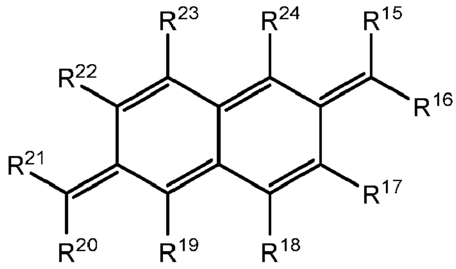

(XXIb),

wherein $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{22}$, $R^{23}$ and $R^{24}$ are independently selected from H, halogen and above mentioned electron withdrawing groups.

According to one embodiment of the present invention, the radialene compound is selected from formula (XXa):

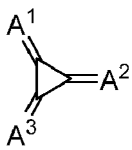

(XXa),

wherein in formula (XXa)

- $A^1$ is independently selected from a group of formula (XXaa)

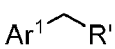

(XXaa),

wherein $Ar^1$ is independently selected from substituted or unsubstituted aryl and substituted or unsubstituted heteroaryl
wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (XXab)

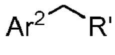

(XXab),

wherein $Ar^2$ is independently selected from substituted or unsubstituted aryl and substituted or unsubstituted heteroaryl
wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are

independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^3$ is independently selected from a group of formula (XXac)

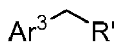

(XXac),

wherein $Ar^3$ is independently selected from substituted or unsubstituted aryl and substituted or unsubstituted heteroaryl
wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl and;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- and wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl,partially fluorinated $C_1$ to $C_8$ alkyl, perfluorinated $C_1$ to $C_8$ alkyl, halogen, F and CN; preferably the radialene compound is selected from 2,2',2"-(cyclopropane-1,2,3-triylidene)tris(2-(p-cyanotetrafluorophenyl)acetonitrile).

Substantially covalent matrix compound

According to one embodiment of the present invention, the hole injection layer, hole transport layer and/or hole blocking layer may comprise a substantially covalent matrix compound.
According to one embodiment of the present invention, the substantially covalent matrix compound may be selected from at least one organic compound. The substantially covalent matrix may consists substantially from covalently bound C, H, O, N, S, which optionally comprise in addition covalently bound B, P, As and/or Se.
According to one embodiment of the present invention, the substantially covalent matrix compound may be selected from organic compounds consisting substantially from covalently bound C, H, O, N, S, which optionally comprise in addition covalently bound B, P, As and/or Se.
According to one embodiment, the substantially covalent matrix compound may have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, in addition preferred a molecular weight Mw of $\geq$ 550 and $\leq$ 900 g/mol, also preferred a molecular weight Mw of $\geq$ 600 and $\leq$ 800 g/mol.
Preferably, the substantially covalent matrix compound comprises at least one arylamine moiety, alternatively a diarylamine moiety, alternatively a triarylamine moiety.
Preferably, the substantially covalent matrix compound is free of metals and/or ionic bonds.
According to another aspect of the present invention, the substantially covalent matrix compound may comprise at least one arylamine compound, diarylamine compound, triarylamine compound, a compound of formula (VII) or a compound of formula (VIII):

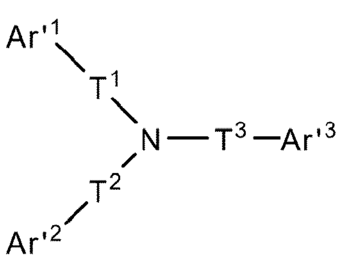

(VII),

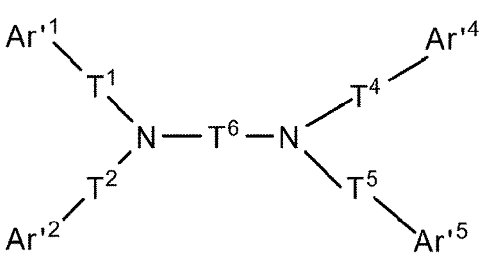

(VIII),

wherein:

$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
Ar’$^1$, Ar’$^2$, Ar’$^3$, Ar’$^4$ and Ar’$^5$are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9’-spirobi[fluorene], substituted or unsubstituted spiro[fluorene-9,9’-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar’$^1$, Ar’$^2$, Ar’$^3$, Ar’$^4$ and Ar’$^5$ are selected the same or different from the group comprising H, D, F, C(=O)R’$^2$, CN, Si(R’$^2$)$_3$, P(=O)(R’$^2$)$_2$, OR’$^2$, S(=O)R’$^2$, S(=O)$_2$R’$^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R’$^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.
According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.
According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.
According to an embodiment wherein Ar’$^1$, Ar’$^2$, Ar’$^3$, Ar’$^4$ and Ar’$^5$ may be independently selected from D1 to D16:

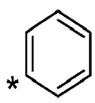 (D1), 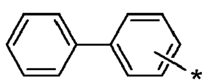 (D2), 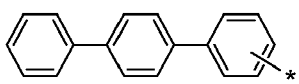 (D3), 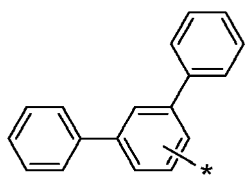 (D4),

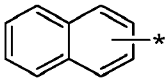 (D5), 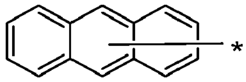 (D6), 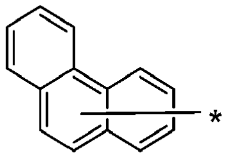 (D7), 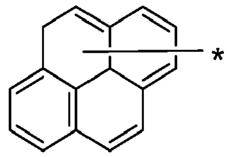 (D8),

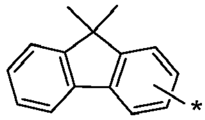 (D9), 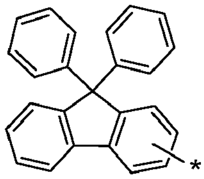 (D10), 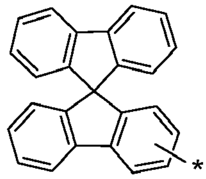 (D11),

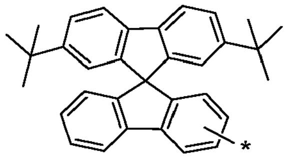 (D12), 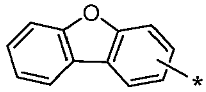 (D13), 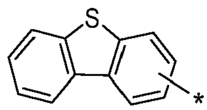 (D14),

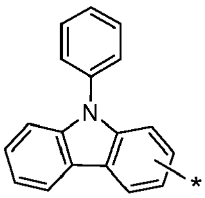 (D15), 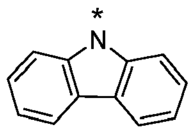 (D16),

wherein the asterix "*" denotes the binding position.

According to an embodiment, wherein $Ar'^1$, $Ar'^2$, $Ar'^3$, $Ar'^4$ and $Ar'^5$ may be independently selected from D1 to D15; alternatively selected from D1 to D10 and D13 to D15.

According to an embodiment, wherein $Ar'^1$, $Ar'^2$, $Ar'^3$, $Ar'^4$ and $Ar'^5$ may be independently selected from the group consisting of D1, D2, D5, D7, D9, D10, D13 to D16.

The rate onset temperature may be in a range particularly suited to mass production, when $Ar'^1$, $Ar'^2$, $Ar'^3$, $Ar'^4$ and $Ar'^5$ are selected in this range.

The "matrix compound of formula (VII) or formula (VIII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (VII) or formula (VIII) are selected from F1 to F20:

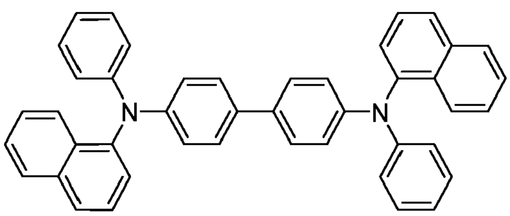 (F1), 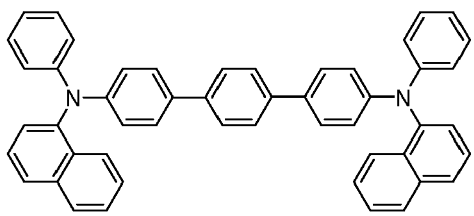 (F2),

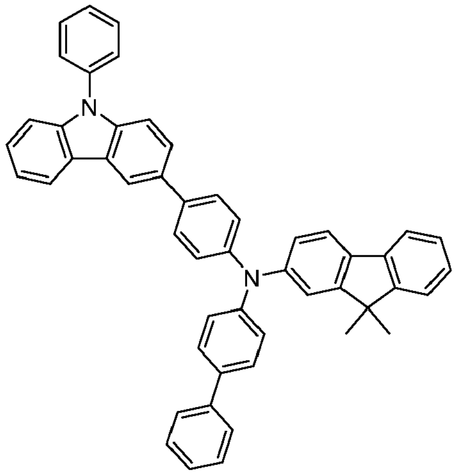 (F3), 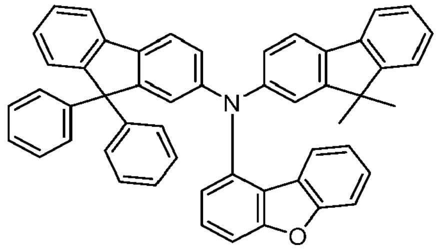 (F4),

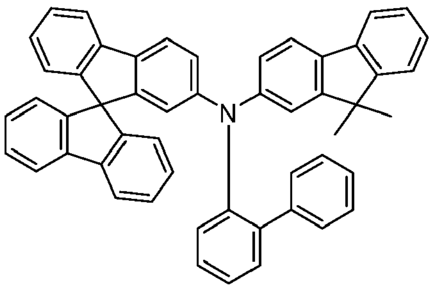 (F5), 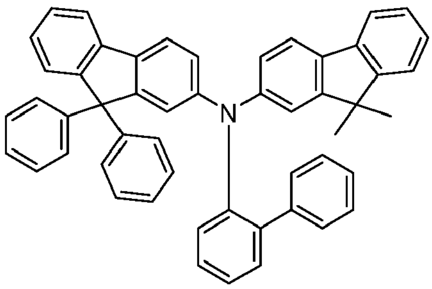 (F6),

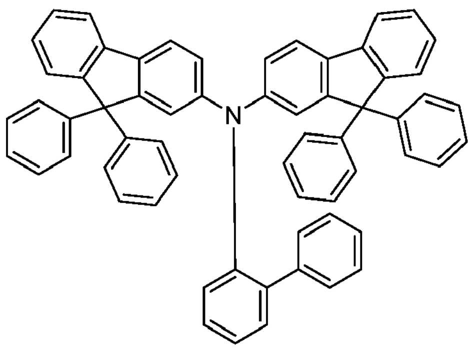 (F7), 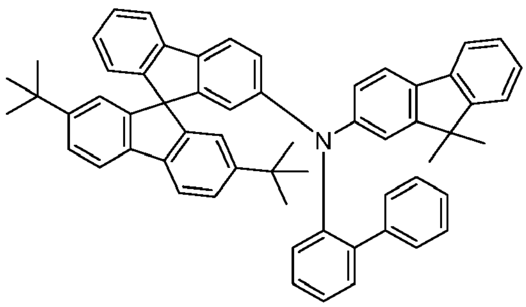 (F8),

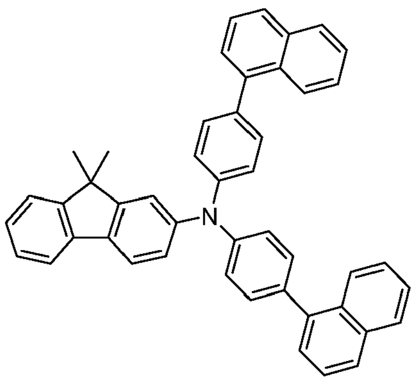 (F9), 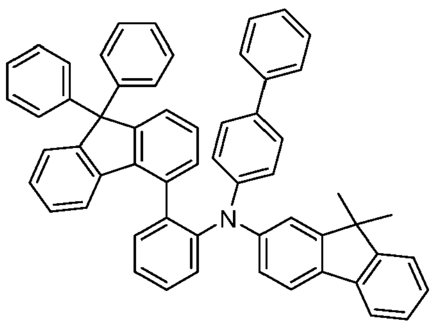 (F10),

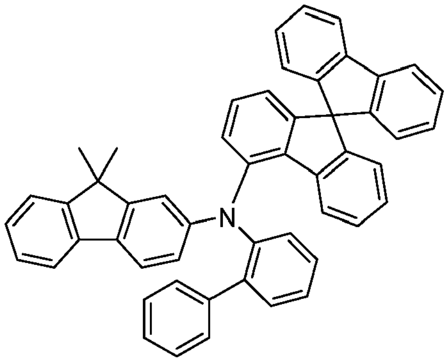

(F11),

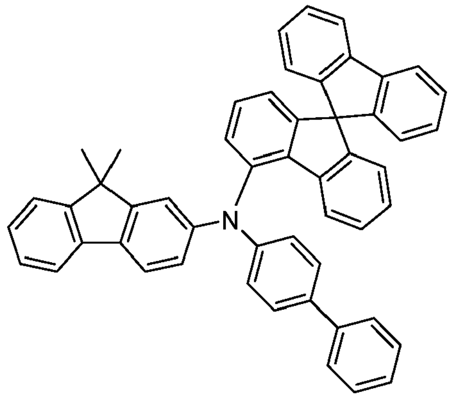

(F12),

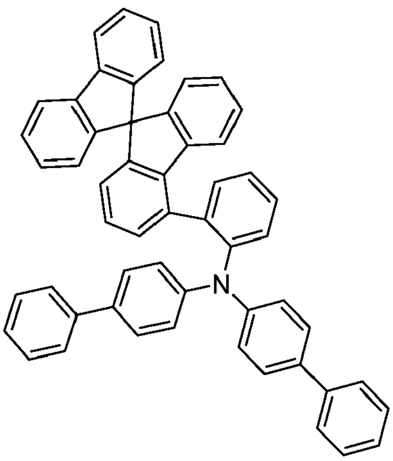

(F13),

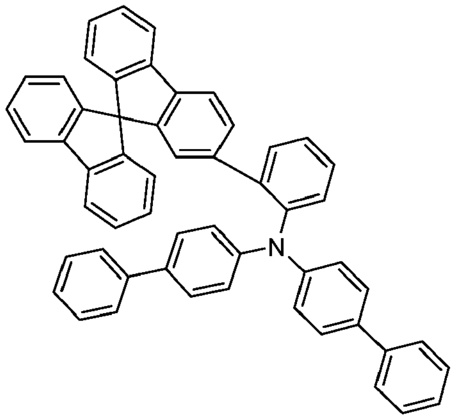

(F14),

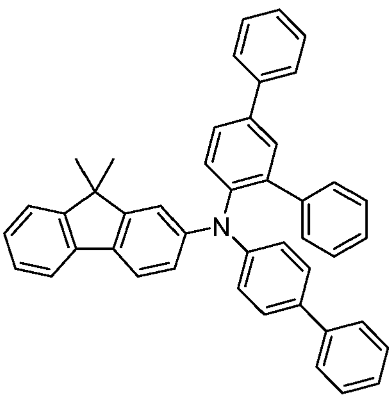

(F15),

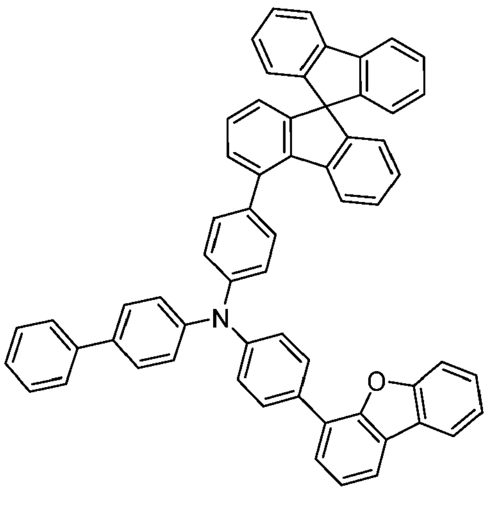

(F16),

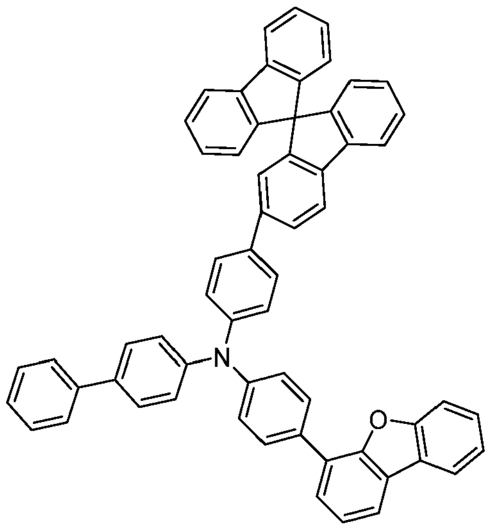
(F17)

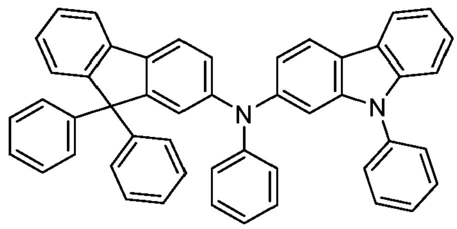
(F18)

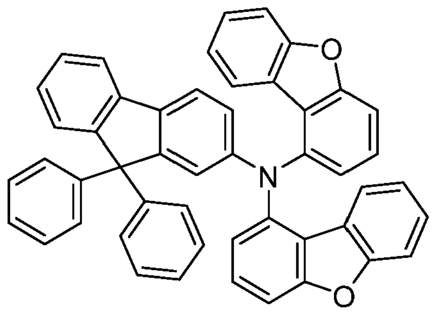
(F19),

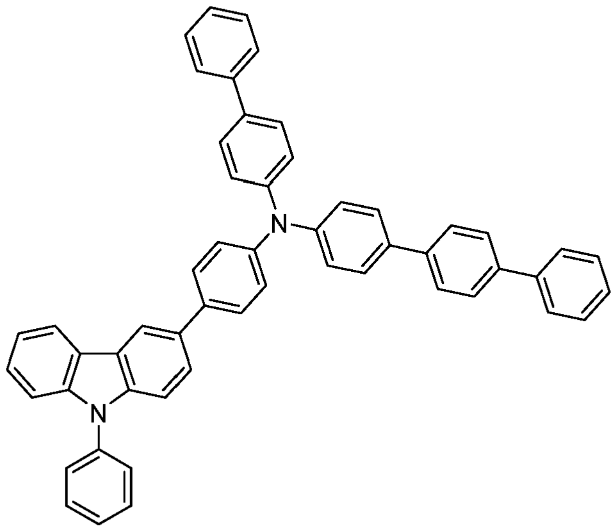
(F20).

*Hole transport layer*

In one embodiment of the present invention, the organic electroluminescent device further comprises a hole transport layer, wherein the hole transport layer is arranged between the hole injection layer and the first emission layer.

The hole transport layer (HTL) may be formed on the anode layer or HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

In one embodiment, the hole transport layer comprises a substantially covalent matrix compound.

In one embodiment of the present invention, the hole injection layer and the hole transport layer comprise a substantially covalent matrix compound, wherein the substantially covalent matrix compound is selected the same in both layers.

In one embodiment, the hole transport layer comprises a compound of formula (VII) or (VIII).

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 110 nm to about 140 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The EML, also named first emission layer, may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.It may be provided that the first emission layer does not comprise the compound of Formula (I) and/or (Ia).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to an embodiment, the first emission layer is arranged between the anode layer and the electron transport layer, preferably the first emission layer is in directed contact with the electron transport layer.

The organic electroluminescent device may further comprise a second emission layer, optionally a third emission layer, wherein the second emission layer and optional third emission layer are arranged between the anode layer and cathode layer.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

Organic electroluminescent device

According to one aspect of the present invention, there is provided an organic electroluminescent device comprising: a substrate; an anode layer formed on the substrate; a first emission layer, an electron transport layer according to invention, an electron injection layer according to invention and a cathode layer according to invention.

According to one aspect of the present invention, there is provided an organic electroluminescent device comprising: a substrate; an anode layer formed on the substrate; a hole injection layer, a hole transport layer, an optional electron blocking layer, a first emission layer, an optional hole blocking layer, an electron transport layer according to invention, an electron injection layer according to invention and a cathode layer according to invention.

According to various embodiments of the present invention, there may be provided further layers arranged between the above mentioned layers, on the substrate or on the top electrode.

According to one embodiment of the invention the organic electroluminescent device is an organic light emitting diode.

The present invention furthermore relates to a display device comprising an organic electroluminescent device according to the present invention.

According to a preferred embodiment of the invention, the display device comprising an organic electroluminescent device according to the present invention, wherein the cathode layer is transparent to visible light.

According to another aspect of the invention, it is provided an electronic device comprising at least one organic electroluminescent device according to any embodiment described throughout this application, preferably, the electronic device comprises the organic light emitting diode in one of embodiments described throughout this application. More preferably, the electronic device is a display device.

Hereinafter, the embodiments are illustrated in more detail with reference to examples. However, the present disclosure is not limited to the following examples. Reference will now be made in detail to the exemplary aspects.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electroluminescent device, according to an exemplary embodiment of the present invention;

FIG. 2 is a schematic sectional view of an organic electroluminescent device, according to an exemplary embodiment of the present invention;

FIG. 3 is a schematic sectional view of an organic electroluminescent device, according to an exemplary embodiment of the present invention;

FIG. 4 is a schematic sectional view of an organic electroluminescent device, according to an exemplary embodiment of the present invention;

FIG. 5 is a schematic sectional view of an organic electroluminescent device, according to an exemplary embodiment of the present invention;

FIG. 6 is a schematic sectional view of an organic electroluminescent device, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there

between. When a first element is referred to as being formed or disposed "directly on" or "directly onto" a second element, no other elements are disposed there between.

FIG. 1 is a schematic sectional view of an organic electroluminescent device 100, according to an exemplary embodiment of the present invention. The organic electroluminescent device 100 includes a substrate 110, an anode layer 120, a first emission layer (EML) 150, an electron transport layer (ETL) 170, an electron injection layer (EIL) 180 and a cathode layer 190. The EML 150 is disposed on the anode layer. Onto the EML 150, the ETL 170, the EIL 180 and the cathode layer 190 are disposed.

FIG. 2 is a schematic sectional view of an organic electroluminescent device 100, according to an exemplary embodiment of the present invention. The organic electroluminescent device 100 includes a substrate 110, an anode layer 120, a first emission layer (EML) 150, an electron transport layer (ETL) 170, an electron injection layer (EIL) 180, wherein the EIL comprises a first EIL sub-layer (EIL1) 181 and a second EIL sub-layer (EIL2) 182, and a cathode layer 190. The EML 150 is disposed on the anode layer. Onto the EML 150, the ETL 170, the EIL 180 and the cathode layer 190 are disposed.

FIG. 3 is a schematic sectional view of an organic electroluminescent device 100, according to an exemplary embodiment of the present invention. The organic electroluminescent device 100 includes a substrate 110, an anode layer 120, a hole injection layer (HIL) 130, a hole transport layer (HTL) 140, a first emission layer (EML) 150, an electron transport layer (ETL) 170, an electron injection layer (EIL) 180 and a cathode layer 190. The HIL 130 is disposed on the anode layer. Onto the HIL 130, the HTL 140, the EML 150, the ETL 170, the EIL 180 and the cathode layer 190 are disposed.

FIG. 4 is a schematic sectional view of an organic electroluminescent device 100, according to an exemplary embodiment of the present invention. The organic electroluminescent device 100 includes a substrate 110, an anode layer 120, a hole injection layer (HIL) 130, a hole transport layer (HTL) 140, an electron blocking layer (EBL) 145, a first emission layer (EML) 150, a hole blocking layer (HBL) 160, an electron transport layer (ETL) 170, an electron injection layer (EIL) 180 and a cathode layer 190. The HIL 130 is disposed on the anode layer. Onto the HIL 130, the HTL 140, the EBL 145, the EML 150, the HBL 160, the ETL 170, the EIL 180 and the cathode layer 190 are disposed.

FIG. 5 is a schematic sectional view of an organic electroluminescent device 100, according to an exemplary embodiment of the present invention. The organic electroluminescent device 100 includes a substrate 110, an anode layer 120, a hole injection layer (HIL) 130, a hole transport layer (HTL) 140, an electron blocking layer (EBL) 145, a first emission layer (EML) 150, a hole blocking layer (HBL) 160, an electron transport layer (ETL) 170, an electron injection layer (EIL) 180, wherein the EIL comprises a first EIL sub-layer (EIL1) 181 and a second EIL sub-layer (EIL2) 182, and a cathode layer 190. The HIL 130 is disposed on the anode layer. Onto the HIL 130, the HTL 140, the EBL 145, the EML 150, the HBL 160, the ETL 170, the EIL 180 and the cathode layer 190 are disposed.

FIG. 6 is a schematic sectional view of an organic electroluminescent device 100, according to an exemplary embodiment of the present invention. The organic electroluminescent device 100 includes a substrate 110, an anode layer 120, wherein the anode layer 120 comprises a first anode sub-layer 121, a second anode sub-layer 122 and a third anode sub-layer 123, a hole injection layer (HIL) 130, a hole transport layer (HTL) 140, an electron blocking layer (EBL) 145, a first emission layer (EML) 150, a hole blocking layer (HBL) 160, an electron transport layer (ETL) 170, an electron injection layer (EIL) 180, wherein the EIL comprises a first EIL sub-layer (EIL1) 181 and a second EIL sub-layer (EIL2) 182, and a cathode layer 190. The HIL 130 is disposed on the anode layer. Onto the HIL 130, the HTL 140, the EBL 145, the EML 150, the HBL 160, the ETL 170, the EIL 180 and the cathode layer 190 are disposed.

While not shown in Fig. 1 to Fig. 6 , a capping and/or sealing layer may further be formed on the cathode layer 190, in order to seal the organic electroluminescent device 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

**Detailed description**

The invention is furthermore illustrated by the following examples which are illustrative only and non-binding.

<u>Calculated HOMO and LUMO of compound of formula (II), compound of formula (III), compound of formula (VII) or (VIII), compound of formula (X), (XI), (XII)</u>

The HOMO and LUMO of compound of formula (II), compound of formula (III), compound of formula (VII) or (VIII), compound of formula (X), (XI), (XII) are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the

gas phase. If more than one conformation is viable, the conformation with the lowest total energy is selected. The HOMO and LUMO levels are recorded in electron volt (eV).

General procedure for fabrication of OLEDs

For all inventive and comparative example (see Tables 6 and 7), a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, 92 vol.-% Biphenyl-4-yl(9,9-diphenyl-9H-fluoren-2-yl)-[4-(9-phenyl-9H-carbazol-3-yl)phenyl]-amine (CAS 1242056-42-3) with 8 vol.-% 2,2',2"-(cyclopropane-1,2,3-triylidene)tris(2-(p-cyanotetrafluorophenyl)acetonitrile) was vacuum deposited on the anode, to form a hole injection layer (HIL) having a thickness of 10 nm.

Then, Biphenyl-4-yl(9,9-diphenyl-9H-fluoren-2-yl)-[4-(9-phenyl-9H-carbazol-3-yl) phenyl]-amine was vacuum deposited on the HIL, to form a first hole transport layer (HTL) having a thickness of 121 nm.

Then N-([1,1'-biphenyl]-4-yl)-9,9-diphenyl-N-(4-(triphenylsilyl)phenyl)-9H-fluoren-2-amine (CAS 1613079-70-1) was vacuum deposited on the HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue dopant were deposited on the EBL, to form a first emission layer (EML) with a thickness of 20 nm.

Then a hole blocking layer (HBL) was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the EML.

Then, the electron transport layer (ETL) having a thickness of 31 nm is formed on the hole blocking layer. The electron transport layer may comprise a composition Comp-1 comprising 30 wt.-% of formula (II) (3-(4-(4-(4,6-diphenyl-1,3,5-triazin-2-yl)phenyl)naphthalen-1-yl)phenyl)dimethyl-phosphine oxide (ETM1) and 70 wt.-% of formula (III) 2-([1,1'-biphenyl]-3-yl)-4-phenyl-6-(3-(10-phenylanthracen-9-yl)phenyl)-1,3,5-triazine (ETM2), see the inventive examples and comparative examples in Table 6 and 7.

Then the electron injection layer (EIL) was deposited on the ETL. The composition and thickness of the EIL can be seen in Tables 6 and 7. The chemical formulas of compounds of formula (I) (as well as (Ia)) are shown in Table 1. In examples wherein the EIL is a single layer comprising a composition comprising compound of formula (I) and/or (Ia) and the metal, the concentration is provided in wt.-%. For example "Yb : LiTFSI (90:10)" is synonymous with a composition comprising 90 wt.-% Yb and 10 wt.-% LiTFSI.

Then, the cathode layer is formed on the electron transport layer having a thickness of 13 nm by depositing Ag:Mg (90:10 vol.-%) at a rate of 0.01 to 1 Å/s at $10^{-7}$ mbar.

Then, N-([1,1'-biphenyl]-4-yl)-9,9-dimethyl-N-(4-(9-phenyl-9H-carbazol-3-yl)phenyl)-9H-fluoren-2-amine was deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in $cd/m^2$ using an Instrument Systems CAS-140CT array spectrometer (calibrated by Deutsche Akkreditierungsstelle (DAkkS)) for each of the voltage values. The cd/A efficiency at 10 $mA/cm^2$ is determined by interpolating the luminance-voltage and current-voltage characteristics, respectively.

In bottom emission devices, the emission is predominately Lambertian and quantified in percent external quantum efficiency (EQE). The light is emitted through the anode layer. To determine the efficiency EQE in % the light output of the device is measured using a calibrated photodiode at 10 mA/cm2.

In top emission devices, the emission is forward directed through the cathode layer, non-Lambertian and also highly dependent on the mirco-cavity. Therefore, the efficiency EQE will be higher compared to bottom emission devices. To determine the efficiency EQE in % the light output of the device is measured using a calibrated photodiode at 10 $mA/cm^2$.

The color space is described by coordinates CIE-x and CIE-y (International Commission on Illumination 1931). For blue emission the CIE-y is of particular importance. A smaller CIE-y denotes a deeper blue color. The cd/A efficiency may be dependent on the CIE-y. Therefore, the cd/A efficiency was divided by the CIE-y to obtain the "color-corrected efficiency", also named "CCEff".

Lifetime LT of the device is measured at ambient conditions (20°C) and 30 $mA/cm^2$, using a Keithley 2400 source meter, and recorded in hours.

The brightness of the device is measured using a calibrated photo diode. The lifetime LT is defined as the time till the brightness of the device is reduced to 97 % of its initial value.

To determine the voltage stability over time U(100h)-(1h), a current density of at 30 $mA/cm^2$ was applied to the device. The operating voltage was measured after 1 hour and after 100 hours, followed by calculation of the voltage stability for the time period of 1 hour to 100 hours. A low value for U(100h)-(1h) denotes a low increase in operating voltage over time and thereby improved voltage stability.

*Proton affinities*

In Table 5, the proton affinity of a range of ligands L of formulae (I) and/or (Ia) are shown.

Table 5: Proton affinity of ligand L of formulae (I) and/or (Ia) and comparative ligand

| Name | Chemical formula | Proton Affinity calculated with ORCA [eV] | Proton Affinity calculated with Turbomole [eV] |
|---|---|---|---|
| G1 | 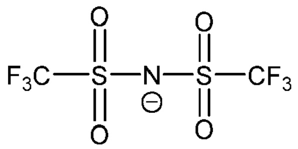 | 13.4 | 13.4 |
| G4 | 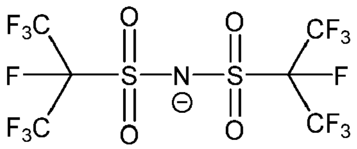 | 13.2 | |
| G5 | 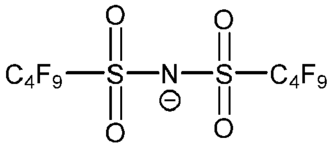 | 13.3 | 13.3 |
| G48 | 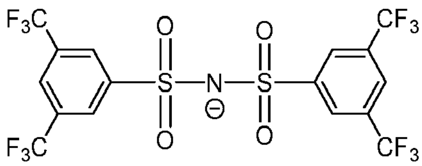 | 13.6 | 13.5 |
| G80 | 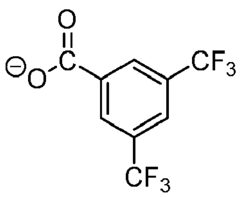 | 14.9 | |
| G77 | 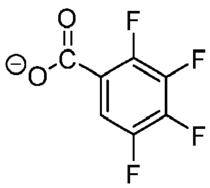 | 15.0 | |

(continued)

| Name | Chemical formula | Proton Affinity calculated with ORCA [eV] | Proton Affinity calculated with Turbomole [eV] |
|---|---|---|---|
| G76 | 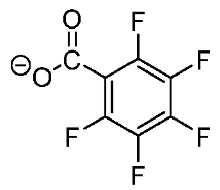 | 14.8 | |
| G54 | 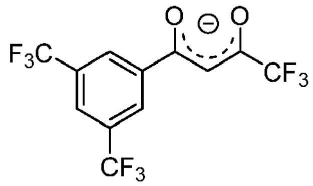 | 14.6 | |
| G70 | 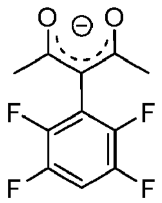 | 15.5 | |
| G71 | 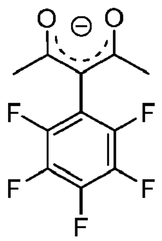 | 15.4 | |
| G72 | 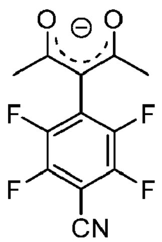 | 15.0 | |
| G73 | 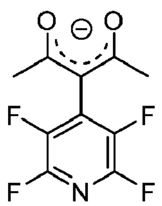 | 15.2 | |
| G74 | 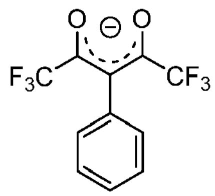 | 14.6 | |

(continued)

| Name | Chemical formula | Proton Affinity calculated with ORCA [eV] | Proton Affinity calculated with Turbomole [eV] |
|---|---|---|---|
| G75 | 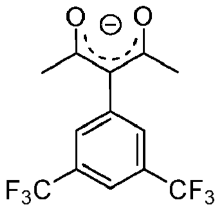 | 15.3 | |
| G90 | 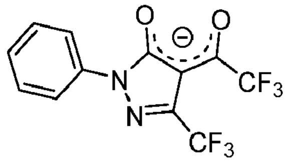 | 14.2 | |
| G82 | 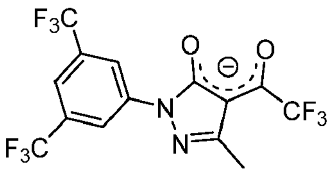 | 14.1 | |
| Comparative ligand 1 CL-1 | 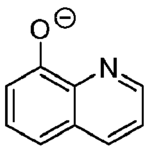 | 15.4 | |

As can be seen in Table 5, the proton affinity of a wide range of ligands has been calculated. When ligand L of formulae (I) and/or (Ia) is selected in this range, particularly efficient electron injection from the cathode layer into the electron transport layer may be achieved.

Comparative ligand 1, also named quinolate, is a ligand known in the art. The proton affinity is 15.4 eV. Comparative ligand 1 is free of fluorine atoms. As can be seen in Table 6, the performance is improved of compounds of formula (I) and/or (Ia) compared to lithium quinolate, also named LiQ.

***Technical Effect of the invention***

Table 6 shows the setup and performance of several comparative and inventive examples.

In Comparative examples C-la to C-1c several setups of an organic luminescent device were used, whereby in C-la only Yb (a metal) was used in the EIL, in C-1b a first EIL sub-layer comprising metal complex lithium quinolate (LiQ) together with a second sub-layer of Yb and in C-1c merely LiTFSI without having a second EIL.

In the inventive examples E-1a and E-1b, LiTFSI and Yb were used, once as separate sublayers (E-1a), once in a single layer (E-1b). Compared to the comparative examples, the voltage stability was increased, in case of C-la and C-1c even significantly increased.

Table 7 shows the setup and performance of several further comparative and inventive examples.

In Table 7, for every comparative example C-X corresponding inventive examples E-X were investigated, where sometimes, as with inventive examples E-1a and E-1b both a dual layer and a single layer setup was investigated, in Examples E-6 and E-7 a single layer was used.

It can be seen that, depending on the example, one or more properties of the corresponding organic electroluminescent device are greatly improved.

Table 6: Setup and performance of several comparative and inventive examples

| | ETL | | EIL | | | | | | | |
|---|---|---|---|---|---|---|---|---|---|---|
| | ETL | Thickness ETL [nm] | Composition EIL1 | Thickness EIL1 [nm] | EIL2 | Thickness EIL2 [nm] | Voltage at $10mA/cm^2$ [V] | CCEff at $10mA/cm^2$ [cd/A] | LT97 at $30mA/cm^2$ [h] | U(100h)-(1h) at $30mA/cm^2$ [V] |
| C-1a | Comp-1 | 31 | Yb | 2 | | | 3.87 | 154 | 82 | 0.133 |
| C-1b | Comp-1 | 31 | LiQ | 1 | Yb | 2 | 3.79 | 151 | 89 | 0.036 |
| C-1c | Comp-1 | 31 | LiTFSI | 1 | | | 7.90 | 110 | 1 | 1.534 |
| E-1a | Comp-1 | 31 | LiTFSI | 1 | Yb | 2 | 3.79 | 158 | 90 | 0.026 |
| E-1b | Comp-1 | 31 | Yb:LiTFSI (90:10) | 2 | | | 3.82 | 160 | 92 | 0.047 |

Table 7: Setup and performance of several comparative and inventive examples

| | ETL | | EIL | | | | | | | |
|---|---|---|---|---|---|---|---|---|---|---|
| | ETL | Thickness ETL [nm] | Composition EIL1 | Thickness EIL1 [nm] | EIL2 | Thickness EIL2 [nm] | Voltage at $10mA/cm^2$ [V] | CCEff at $10mA/cm^2$ [cd/A] | LT97 at $30mA/cm^2$ [h] | U(100h)-(1h) at $30mA/cm^2$ [V] |
| C-2 | Comp-1 Comp-1 | 31 | I-1 | 1 | | | 8.72 | 99 | 1 | 1.883 |
| E-2a | Comp-1 | 31 | I-1 | 1 | Yb | 2 | 3.75 | 159 | 70 | 0.042 |
| E-2b | Comp-1 | 31 | Ib:I-1 (90:10) | 2 | | | 3.83 | 162 | 89 | 0.043 |
| C-3 | Comp-1 | 31 | 1-2 | 1 | | | 9.03 | 94 | 1 | 1.521 |
| E-3a | Comp-1 | 31 | 1-2 | 1 | Yb | 2 | 3.77 | 160 | 83 | 0.035 |
| E-3b | Comp-1 | 31 | Yb : 1-2 (90: 10) | 2 | | | 3.83 | 163 | 97 | 0.082 |
| C-4 | Comp-1 | 31 | 1-3 | 1 | | | 5.96 | 108 | 2 | 0.933 |
| E-4a | Comp-1 | 31 | 1-3 | 1 | Yb | 2 | 3.83 | 156 | 91 | 0.045 |
| E-4b | Comp-1 | 31 | Yb : 1-3 (90: 10) | 2 | | | 3.86 | 158 | 99 | 0.076 |
| C-5 | Comp-1 | 31 | 1-4 | 1 | | | 4.84 | 129 | 2 | 1.068 |
| E-5a | Comp-1 | 31 | 1-4 | 1 | Yb | 2 | 3.79 | 159 | 79 | 0.036 |
| E-5b | Comp-1 | 31 | Yb : 1-4 (90: 10) | 2 | | | 3.87 | 164 | 105 | 0.099 |
| C-6 | Comp-1 | 31 | 1-5 | 1 | | | 6.07 | 106 | 3 | 1.060 |

(continued)

| | ETL | | EIL | | | | | | | |
|---|---|---|---|---|---|---|---|---|---|---|
| | ETL | Thickness ETL [nm] | Composition EIL1 | Thickness EIL1 [nm] | EIL2 | Thickness EIL2 [nm] | Voltage at 10mA/cm$^2$ [V] | CCEff at 10mA/cm$^2$ [cd/A] | LT97 at 30mA/cm$^2$ [h] | U(100h)-(1h) at 30mA/cm$^2$ [V] |
| E-6 | Comp-1 | 31 | Yb : 1-5 (89: 11) | 2 | | | 3.87 | 158 | 106 | 0.087 |
| C-7 | Comp-1 | 31 | 1-6 | 1 | | | 5.34 | 121 | 2 | 1.170 |
| E-7 | Comp-1 | 31 | Yb : 1-6 (90: 10) | 2 | | | 3.89 | 164 | 92 | 0.144 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic electroluminescent device comprising an anode layer, a cathode layer, a first emission layer (EML) and an electron injection layer (EIL), wherein the EML and EIL are arranged between the anode layer and the cathode layer and the EIL is in direct contact with the cathode layer, whereby
the EIL comprises at least one compound of formula (I)

$$M^{n\oplus}(L^{\ominus})_n(AL)_m \qquad (I),$$

wherein

M is a metal ion,
n is an integer selected from 1 to 4, which corresponds to the oxidation number of M;
L is an anionic ligand, wherein the proton affinity of L is selected in the range of ≥ 10 eV and ≤ 15.6 eV and wherein L comprises at least four fluorine atoms;
AL is an ancillary ligand;
m is an integer selected from 0 to 2;
whereby the EIL comprises at least one metal; and
whereby cathode layer comprises ≥ 50 vol.-% and ≤ 100 vol.-% Ag.

2. An organic electroluminescent device comprising an anode layer, a cathode layer, a first emission layer (EML) and an electron injection layer (EIL), wherein the EML and EIL are arranged between the anode layer and the cathode layer and the EIL is in direct contact with the cathode layer, whereby
the EIL comprises at least one compound of formula (Ia)

$$M^{n\oplus}(L^{\ominus})_n(AL)_m \qquad (Ia),$$

wherein

M is a metal ion,
n is an integer selected from 1 to 4, which corresponds to the oxidation number of M;
L is an anionic ligand comprising at least 15 covalently bound atoms, wherein at least two atoms are selected from carbon atoms, and wherein L comprises at least four fluorine atoms;
AL is an ancillary ligand;
m is an integer selected from 0 to 2;
whereby the EIL comprises at least one metal; and
whereby cathode layer comprises ≥ 50 vol.-% and ≤ 100 vol.-% Ag.

3. The organic electroluminescent device according to claim 1 or 2, wherein the organic electroluminescent device further comprises an electron transport layer (ETL), wherein the electron transport layer is arranged between the first emission layer and the electron injection layer, whereby the ETL comprises at least one compound of formula (II):

$$(Ar^2)_m-(Z_k-G)_n \qquad (II);$$

whereby m and n are independently 1 or 2;
k is independently 0, 1 or 2;

$Ar^2$ is independently selected from the group consisting of $C_2$ to $C_{42}$ heteroaryl and $C_6$ to $C_{60}$ aryl, wherein each $Ar^2$ may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; wherein each $C_6$ to $C_{12}$ aryl substituent on $Ar^2$ and each $C_3$ to $C_{11}$ heteroaryl substituent on $Ar^2$ may be substituted with $C_1$ to $C_4$ alkyl or halogen;

Z is independently selected from $C_6$ to $C_{30}$ aryl,

wherein each Z may be substituted with one or two substituents independently selected from the group consisting of $C_6$ to $C_{12}$ aryl and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

wherein each $C_6$ to $C_{12}$ aryl substituent on Z may be substituted with $C_1$ to $C_4$ alkyl or halogen; and

G is chosen so that the dipole moment of a compound G-phenyl is $\geq 1$ D and $\leq 7$ D.

**4.** An organic electroluminescent device according to claims 1 to 3, whereby the electron injection layer (EIL) comprises a first EIL sub-layer (EIL1) and a second EIL sub-layer (EIL2), wherein the first EIL sub-layer is arranged closer to the anode layer and the second EIL sub-layer is arranged closer to the cathode layer; and wherein the first EIL sub-layer comprises the compound of formula (I) and/or (Ia) and the second EIL sub-layer comprises the metal.

**5.** The organic electroluminescent device according to any one of claims 1 to 4, whereby in formula (I) and/or (Ia) L is selected from formulas La to Lc,

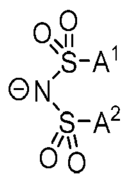 (La), 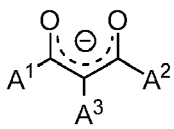 (Lb), and 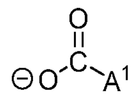 (Lc),

wherein

$A^1$ and $A^2$ are independently selected from substituted or unsubstituted $C_1$ to $C_{12}$ alkyl, substituted or unsubstituted $C_6$ to $C_{12}$ aryl, substituted or unsubstituted $C_3$ to $C_{12}$ heteroaryl;

wherein the substituents of $A^1$ and $A^2$ may be independently selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^1$, $COOR^1$, $SO_2R^1$, halogen, F or CN,

wherein $R^1$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy;

$A^3$ is selected from CN, substituted or unsubstituted $C_1$ to $C_4$ alkyl, especially partially or perfluorinated $C_1$ to $C_4$ alkyl; or whereby $A^3$ is selected as to form a cyclic structure with either $A^1$ or $A^2$, whereby 5- or 6-membered aliphatic or aromatic rings are preferred and whereby the ring may comprise one or more heteroatoms, preferably selected from N, O and S; and

wherein L comprises at least four fluorine atoms.

**6.** The organic electroluminescent device according to any of the claims 1 to 5, wherein the ligand L of formula (I) and/or (Ia) may be selected from G1 to G111:

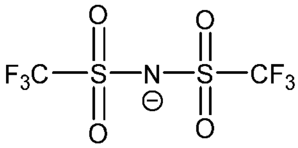 , 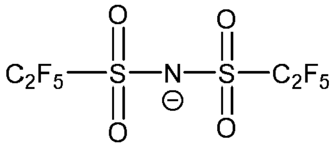 , 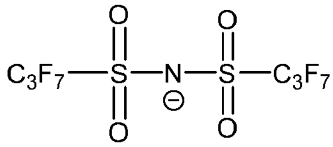 ,

(G1) (G2) (G3)

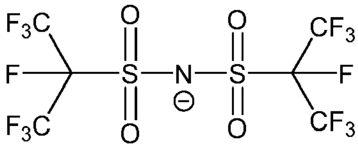 , 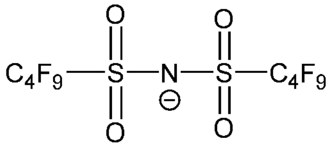 , 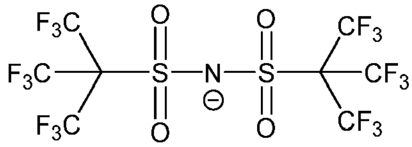 ,

(G4) (G5) (G6)

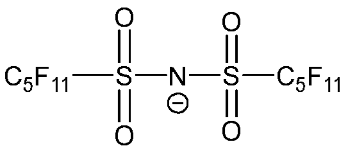 , 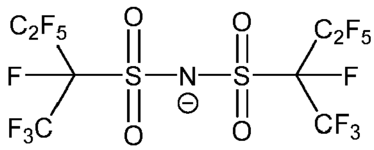 , 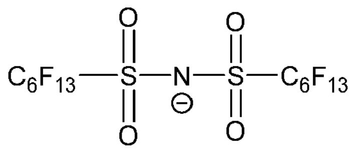 ,

(G7) (G8) (G9)

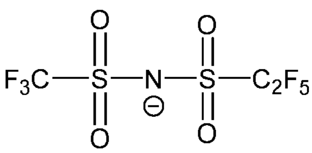 , 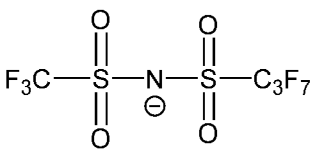 , 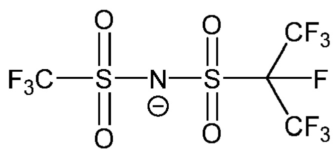 ,

(G10) (G11) (G12)

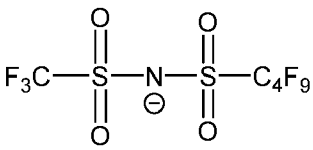 , 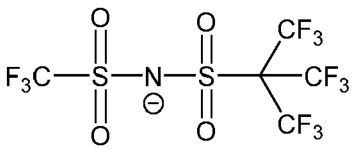 , 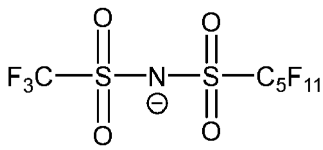 ,

(G13) (G14) (G15)

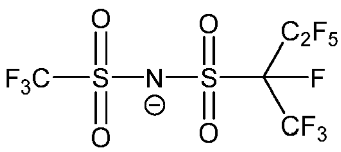 , 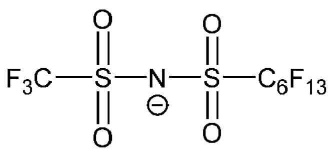 ,

(G16) (G17)

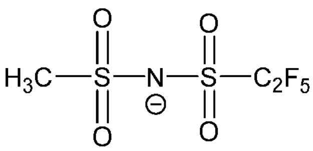 , 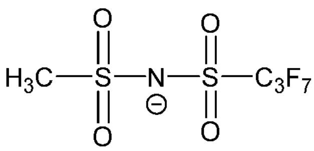 , 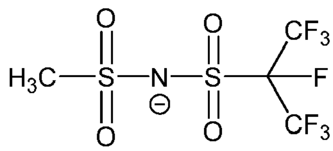 ,

(G18) (G19) (G20)

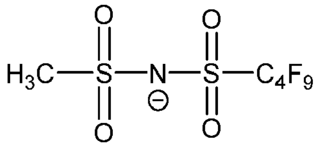 , 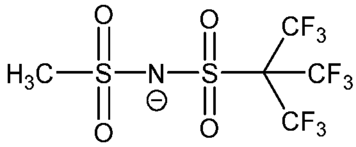 , 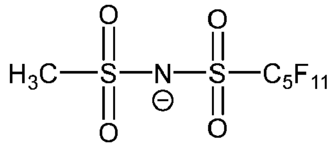 ,

(G21) (G22) (G23)

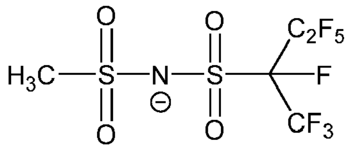 , 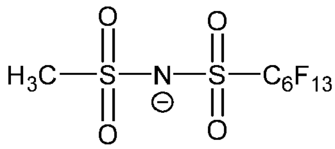 ,

(G24) (G25)

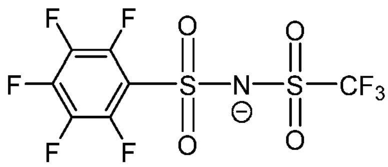 , 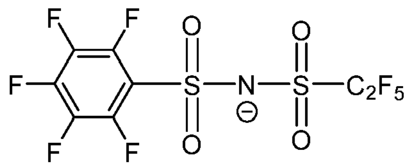 ,

(G26) (G27)

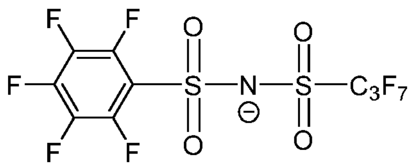 ,

(G28)

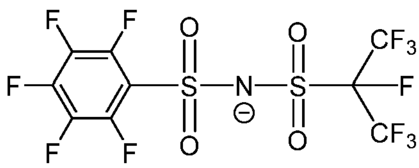 , 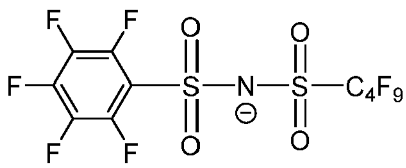 ,

(G29) (G30)

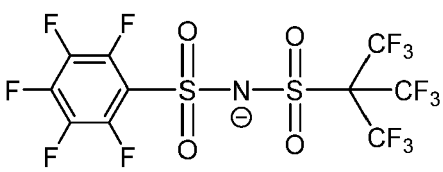 , 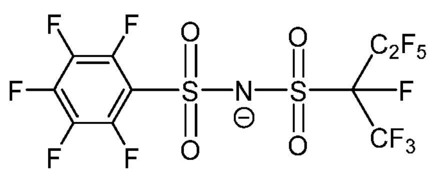 ,

(G31) (G32)

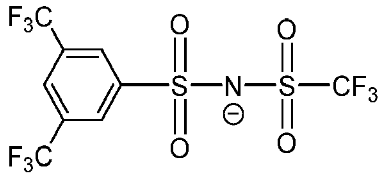, 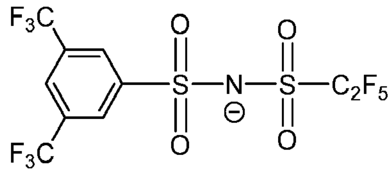, 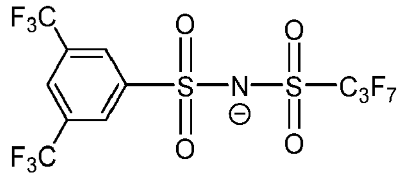,

(G33) (G34) (G35)

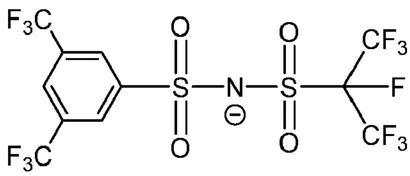, 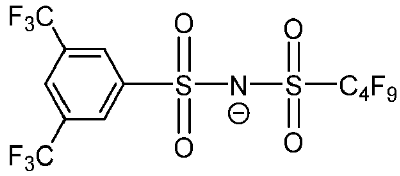,

(G36) (G37)

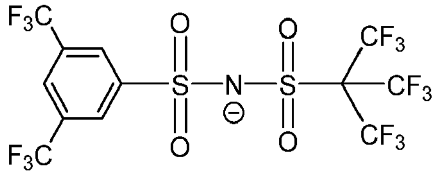,

(G38)

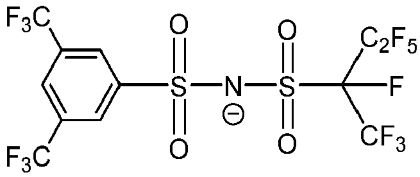, 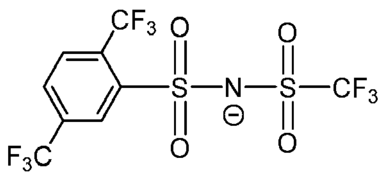,

(G39) (G40)

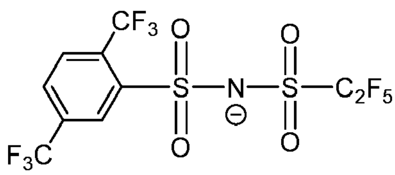,

(G41)

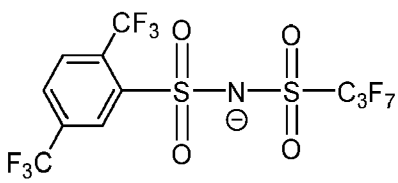, 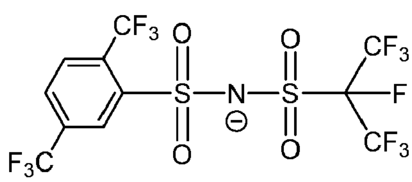,

(G42) (G43)

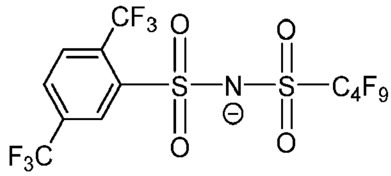
,
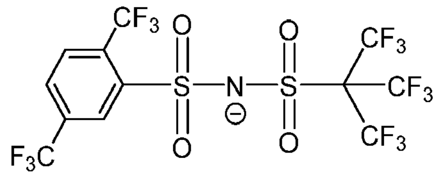

(G44) (G45)

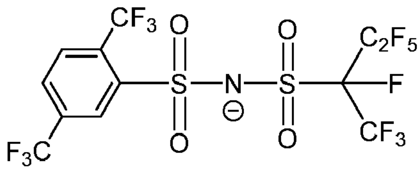
,
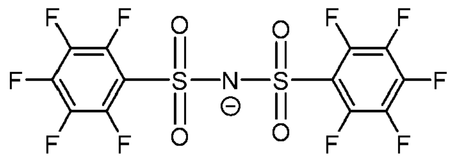

(G46) (G47)

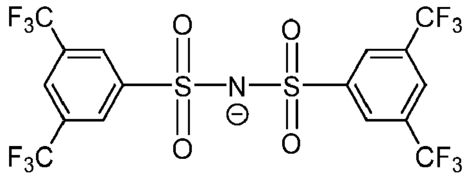
,
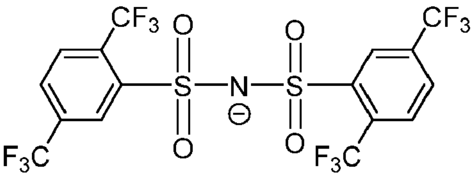
,

(G48) (G49)

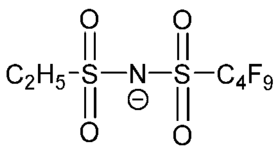
,
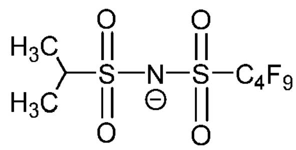
,
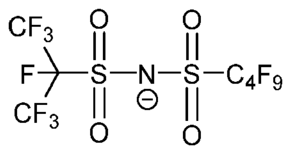
,

(G50) (G51) (G52)

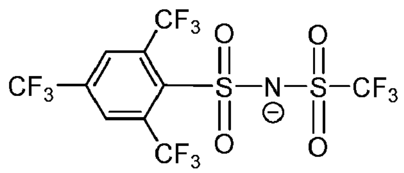

(G53),

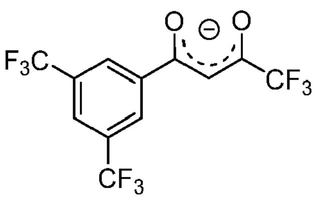
,
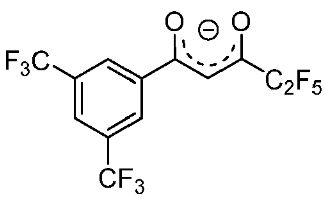
,
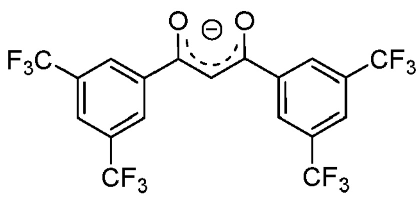
,

(G54) (G55) (G56)

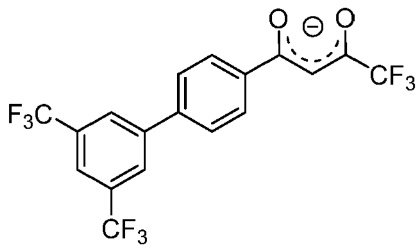,
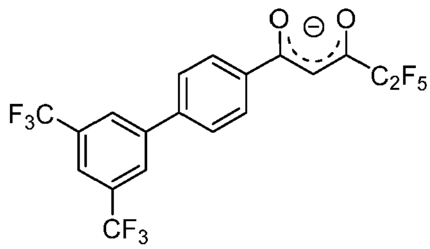,

(G57) (G58)

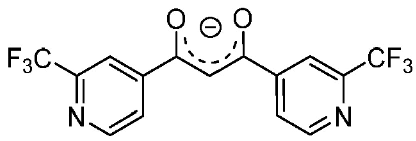,
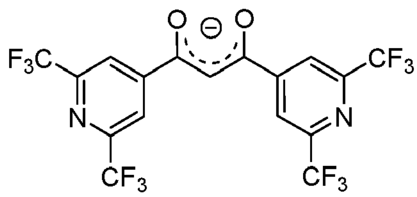,

(G59) (G60)

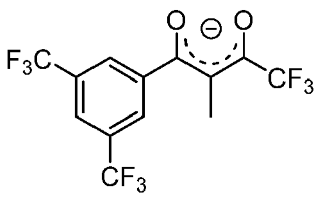,
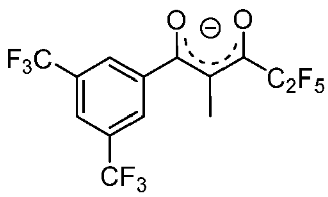,
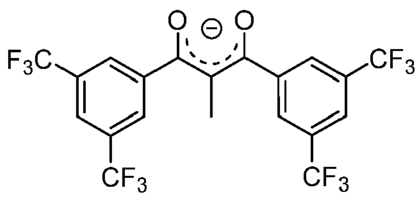,

(G61) (G62) (G63)

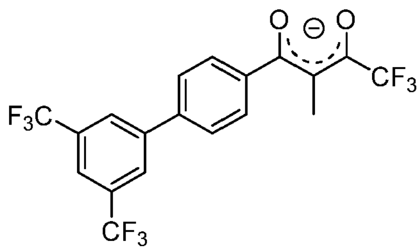,
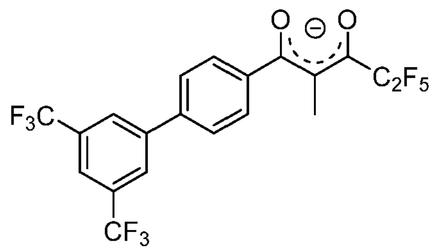,

(G64) (G65)

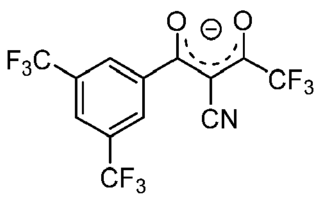,
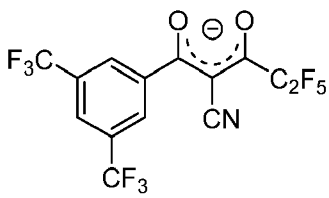,
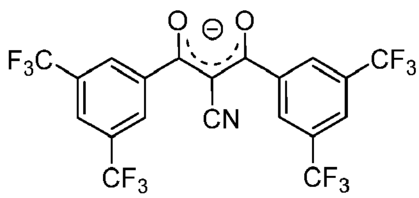,

(G66) (G67) (G68)

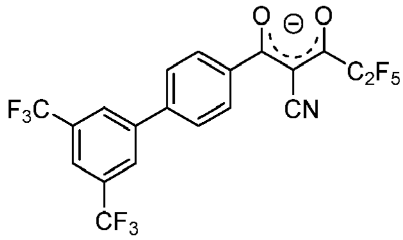 (G69), 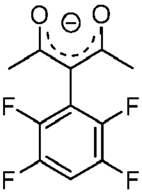 (G70), 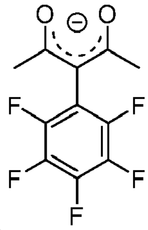 (G71), 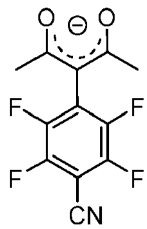 (G72),

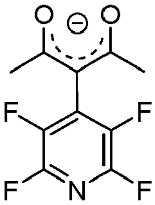 (G73), 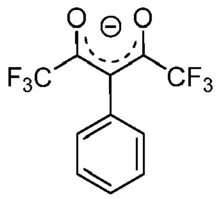 (G74), 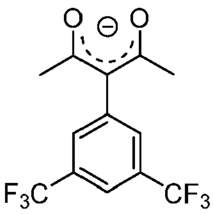 (G75), 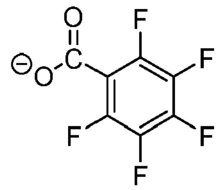 (G76),

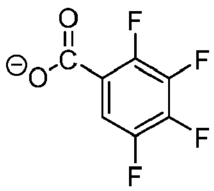 (G77), 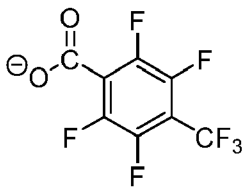 (G78), 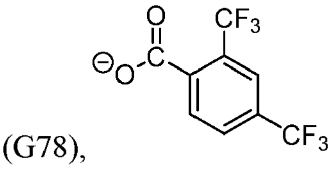 (G79),

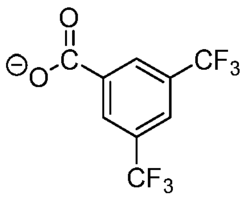 (G80), 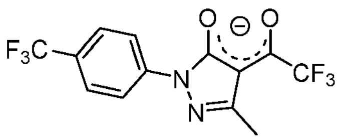 (G81), 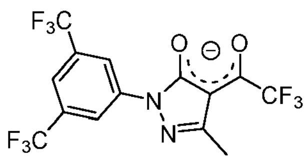 (G82),

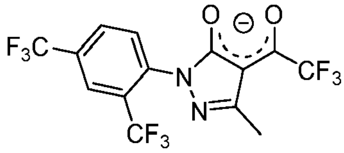 (G83), 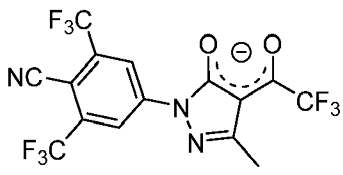 (G84),

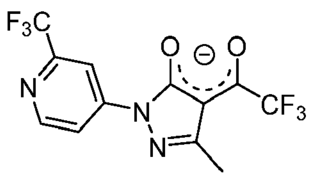 (G85), 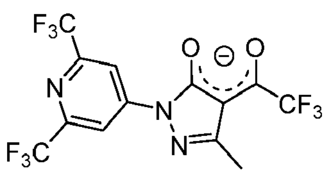 (G86), 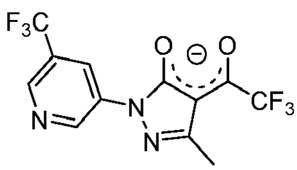 (G87),

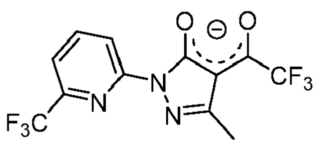 (G88), 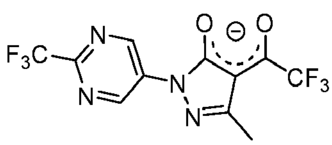 (G89), 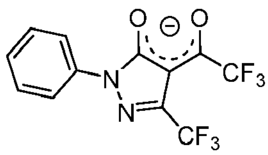 (G90),

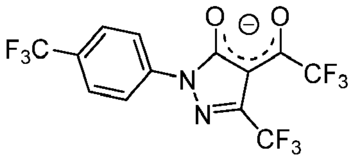 (G91), 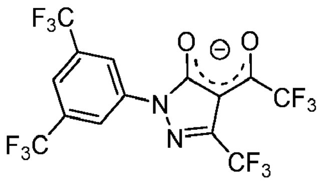 (G92),

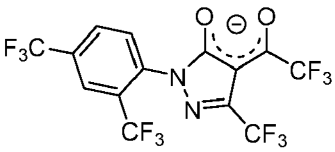 (G93), 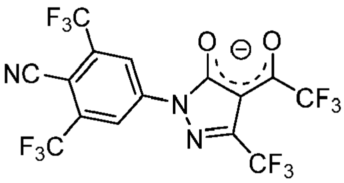 (G94),

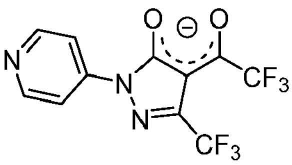 (G95), 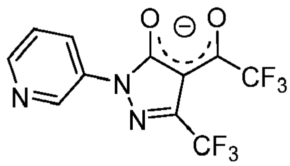 (G96), 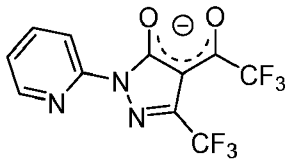 (G97),

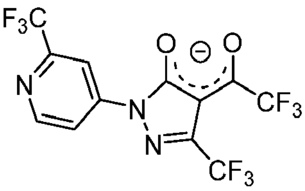 (G98), 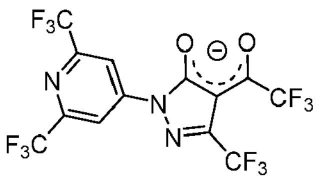 (G99), 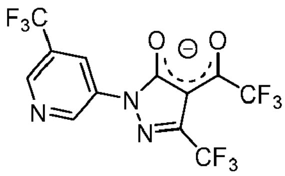 (G100),

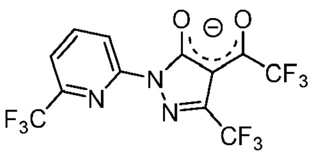 (G101), 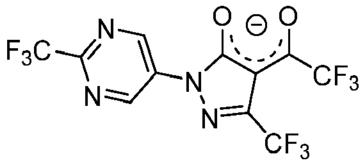 (G102),

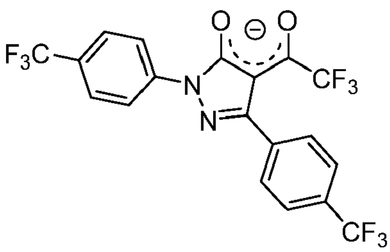 (G103), 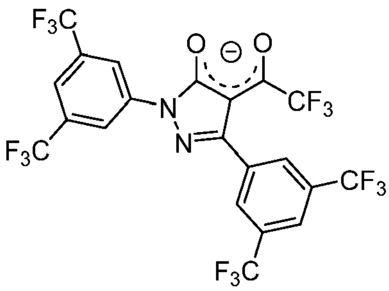 (G104),

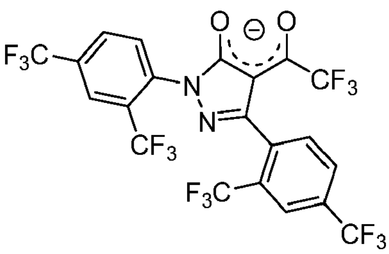 (G105), 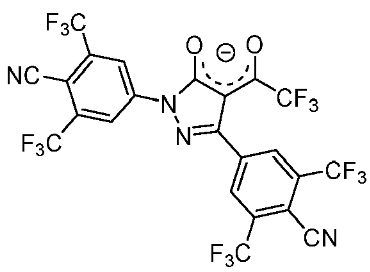 (G106),

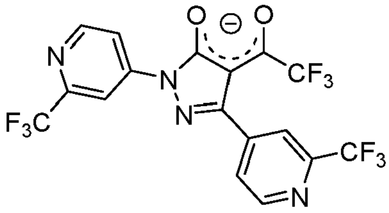 (G107), 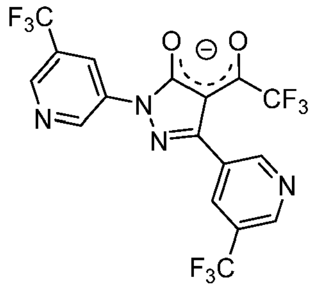 (G108),

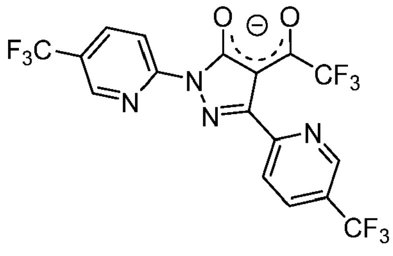 (G109), 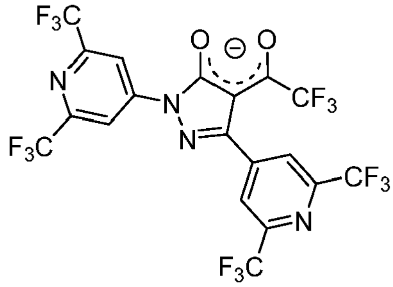 (G110),

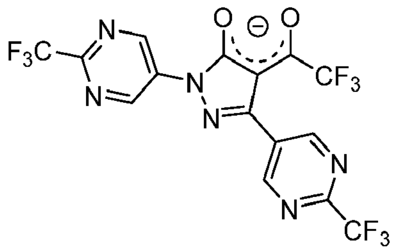 (G111).

7. The organic electroluminescent device according to any of the claims 1 to 6, wherein the compound of formula (I) and/or (Ia) is selected from:
LiTFSI, K TFSI, Cs TFSI, Ag TFSI, $Mg(TFSI)_2$, $Mn(TFSI)_2$, $Sc(TFSI)_3$, $Na[N(SO_2C_4F_9)_2]$, $K[N(SO_2C_4F_9)_2]$, $Mg[N(SO_2{}^iC_3F_7)_2]_2$, $Zn[N(SO_2{}^iC_3F_7)_2]_2$, $Ag[N(SO_2{}^iC_3F_7)_2]$, $Ag[N(SO_2C_3F_7)_2]$, $Ag[N(SO_2C_4F_9)_2]$, $Ag[N(SO_2CF_3)(SO_2C_4F_9)]$, $Cs[N(SO_2C_4F_9)_2]$, $Mg[N(SO_2C_4F_9)_2]_2$, $Ca[N(SO_2C_4F_9)_2]_2$, $Ag[N(SO_2C_4F_9)_2]$, $Cu[N(SO_2{}^iC_3F_7)_2]_2$, $Cu[N(SO_2C_3F_7)_2]_2$, $Cu[N(SO_2CF_3)\ (SO_2C_4F_9)]_2$, $Cu\ [N(SO_2C_2H_5)\ (SO_2C_4F_9)]_2$, $Cu\ [N(SO_2{}^iC_3H_7)\ (SO_2C_4F_9)]_2$, $Cu\ [N(SO_2{}^iC_3F_7)\ (SO_2C_4F_9)]_2$, $Cu[N(SO_2CH_3)\ (SO_2C_4F_9)]_2$, $Mg[N(SO_2CF_3)\ (SO_2C_4F_9)]_2$, $Mn[N(SO_2CF_3)\ (SO_2C_4F_9)]_2$, $Ag[N(SO_2CH_3)\ (SO_2C_4F_9)]$,

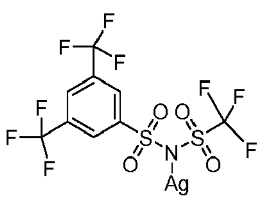, 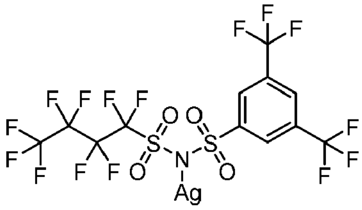, 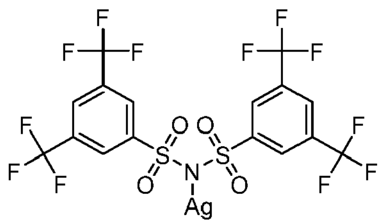,

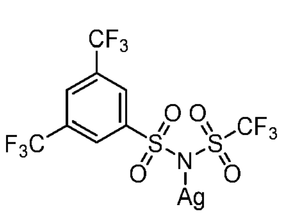, 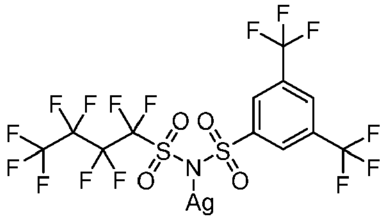, 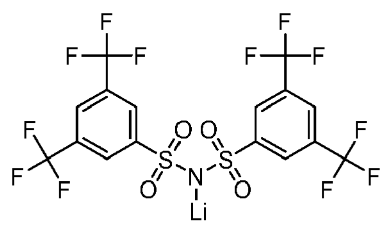,

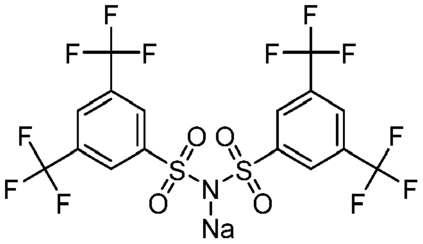,
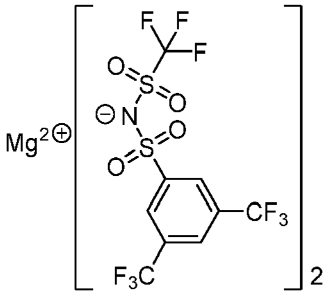,
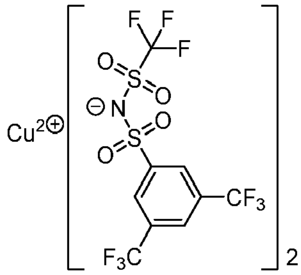,

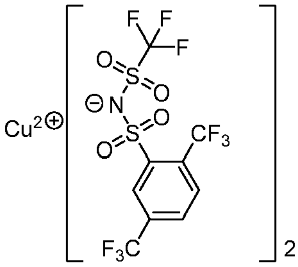,
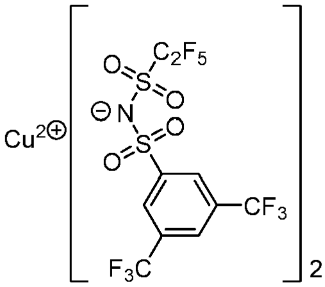,
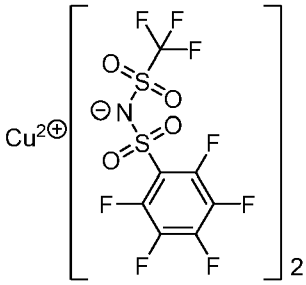,

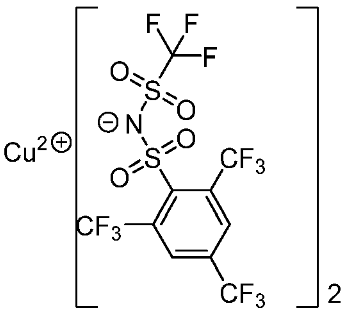,
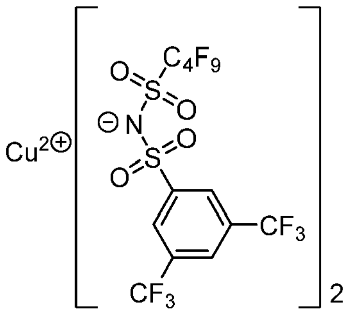,
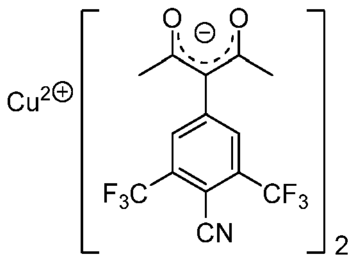,

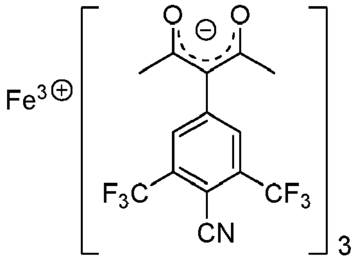,
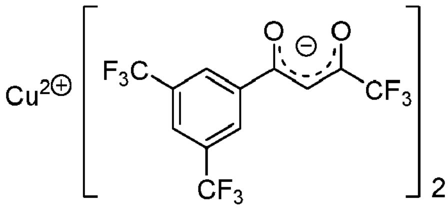,

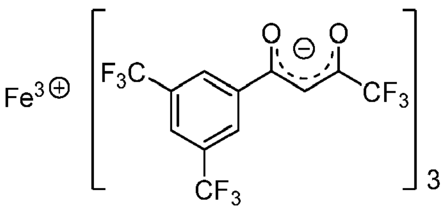,
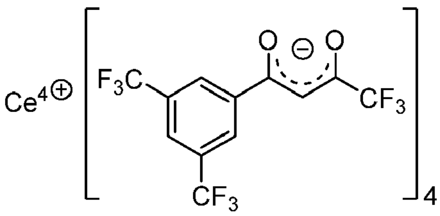,

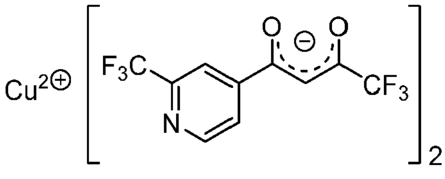, 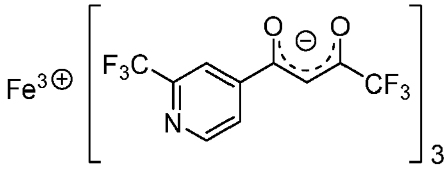,

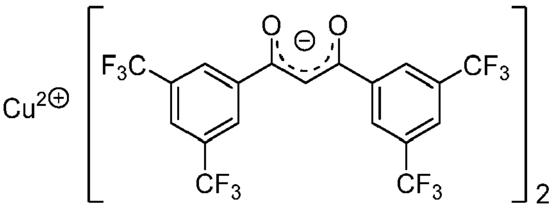, 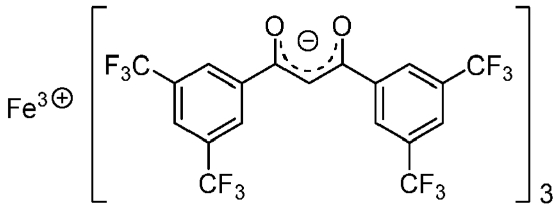,

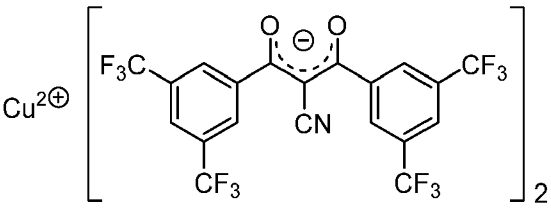, 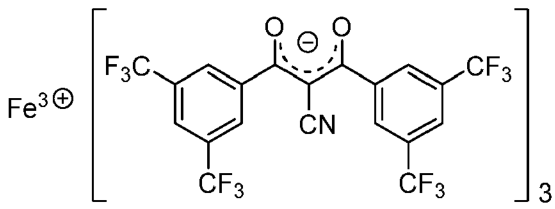,

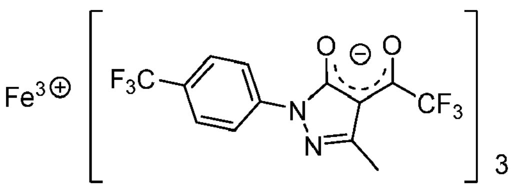, 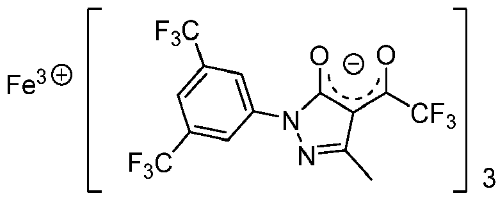,

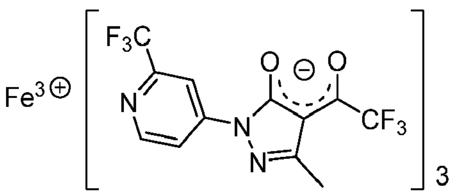, 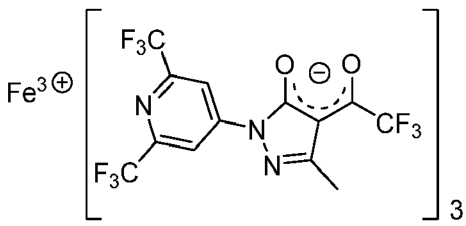,

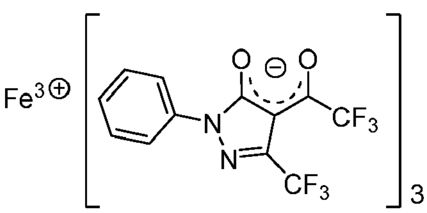, 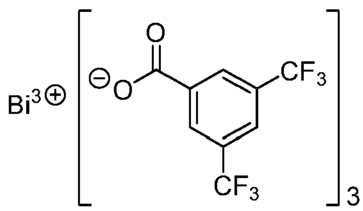,

wherein "1" denotes "iso".

8. The organic electroluminescent device according to any one of claims 1 to 7, whereby the whereby the EIL has a thickness of ≥ 1 nm and ≤ 10 nm.

9. The organic electroluminescent device according to any one of claims 1 to 8, wherein the ETL is essentially free of a metal organic complex.

**10.** The organic electroluminescent device according to any one of claims 1 to 9, wherein the compound of formula (II) comprises a CN or PO group.

**11.** The organic electroluminescent device according to any one of claims 1 to 10, whereby the ETL further comprises a compound of formula (III):
Formula (III): An organic compound having 8 to 13 aromatic or heteroaromatic rings.

**12.** The organic electroluminescent device according to any one of claims 1 to 11, further comprises a hole injection layer, wherein the hole injection layer is arranged between the anode layer and the first emission layer, and wherein the hole injection layer comprises a compound of formula (I) and/or (Ia).

**13.** The organic electroluminescent device according to any of the claims 1 to 12, whereby the organic electroluminescent device is an organic light emitting diode.

**14.** The organic electroluminescent device according to any of the claims 1 to 13, wherein light is emitted through the cathode layer.

**15.** A display device comprising an organic electroluminescent device according to any of the claims 1 to 14.

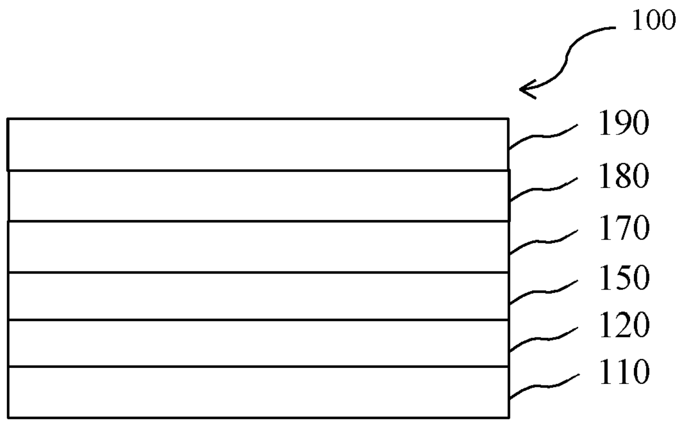


Fig. 1

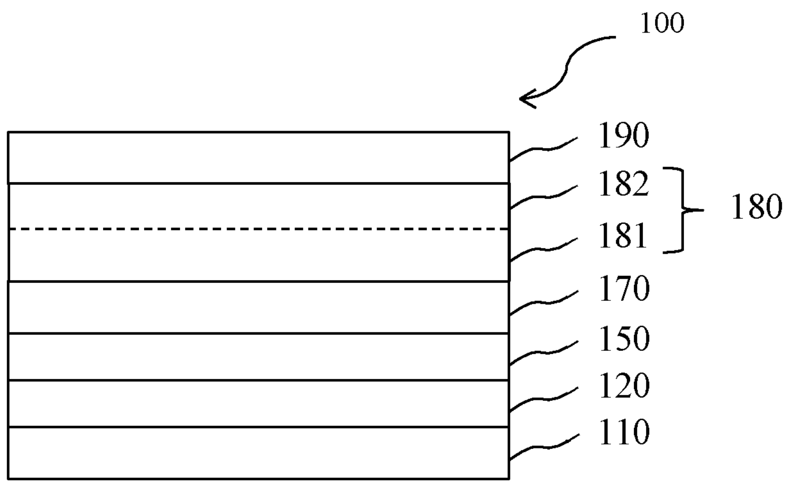


Fig. 2

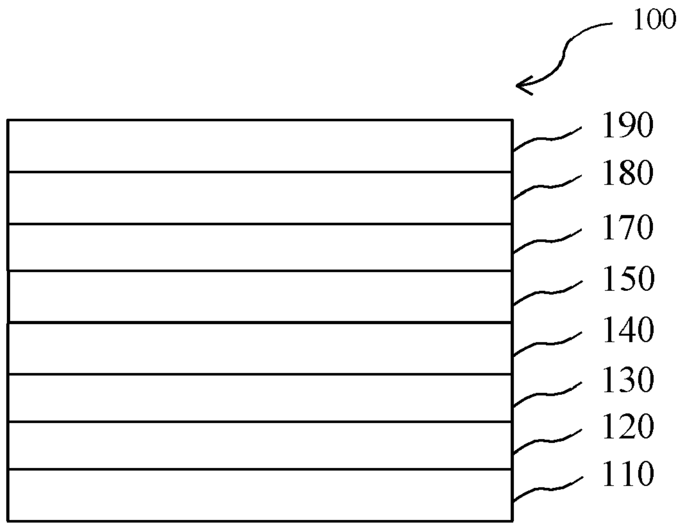


Fig. 3

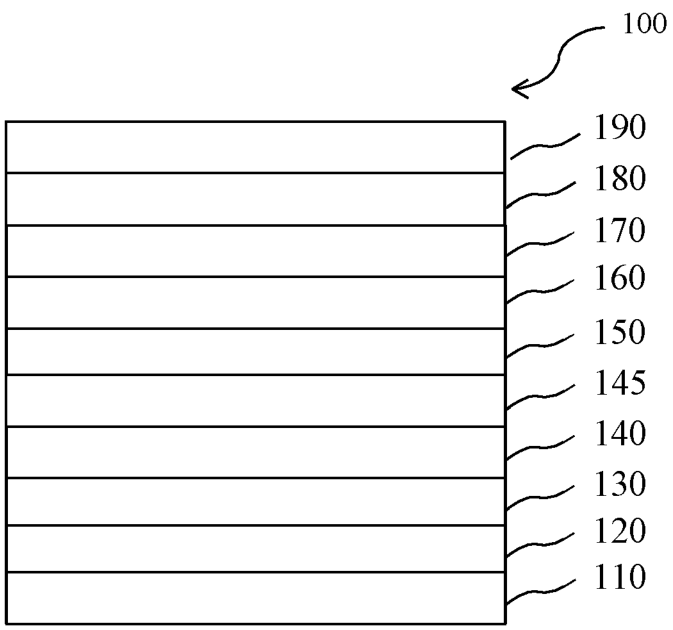


Fig. 4

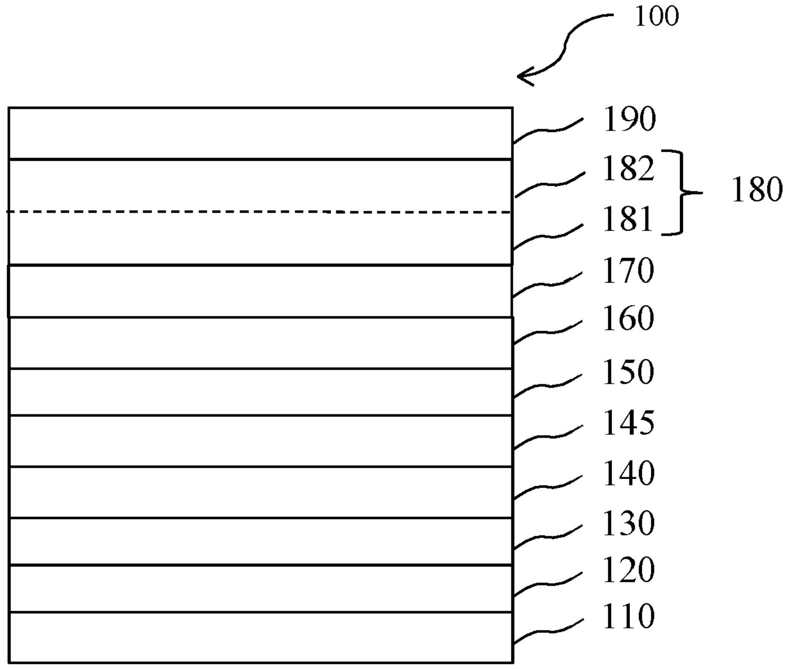


Fig. 5

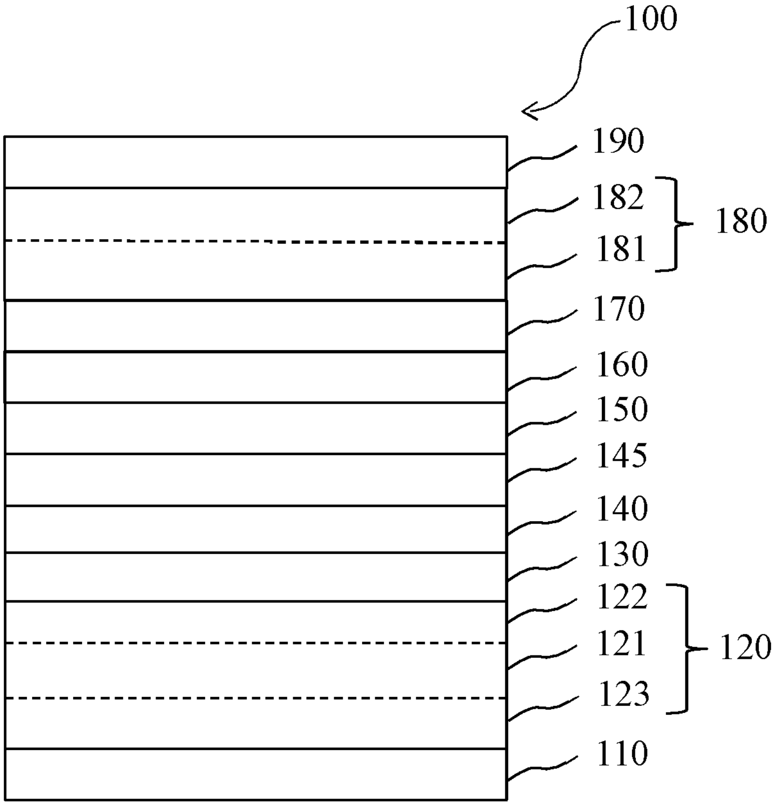


Fig. 6

Europäisches Patentamt
European Patent Office
Office européen des brevets

# PARTIAL EUROPEAN SEARCH REPORT

under Rule 62a and/or 63 of the European Patent Convention. This report shall be considered, for the purposes of subsequent proceedings, as the European search report

Application Number
EP 22 20 9654

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2009/211640 A1 (LEE MOON-JAE [KR] ET AL) 27 August 2009 (2009-08-27)<br>* paragraphs [0119] - [0120] *<br>* paragraph [0109] *<br>* paragraph [0006] *<br>----- | 2,3,5-15 | INV.<br>H10K85/30<br>H10K50/17<br><br>ADD.<br>H10K50/828<br>H10K50/16 |
| T | WO 2019/176982 A1 (SEKISUI CHEMICAL CO LTD [JP]) 19 September 2019 (2019-09-19)<br>* paragraph [0009] *<br>----- | 2 | |
| Y | US 2018/076397 A1 (FREY JULIEN [DE] ET AL) 15 March 2018 (2018-03-15)<br>* paragraph [0076] *<br>----- | 2,3,5-15 | |
| Y | EP 3 480 192 B1 (NOVALED GMBH [DE]) 23 December 2020 (2020-12-23)<br>* paragraph [0076]; claim 5; compounds (A), (C) *<br>----- | 3,9-11 | |
| Y | EP 3 338 314 B1 (NOVALED GMBH [DE]) 12 February 2020 (2020-02-12)<br>* paragraph [0221] *<br>-----<br>-/-- | 12 | TECHNICAL FIELDS SEARCHED (IPC)<br>H10K<br>H01L |

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

2

| Place of search | Date of completion of the search | Examiner |
|---|---|---|
| Munich | 2 June 2023 | Beierlein, Udo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04E07)

page 1 of 2

Europäisches Patentamt
European Patent Office
Office européen des brevets

# PARTIAL EUROPEAN SEARCH REPORT

Application Number
EP 22 20 9654

| DOCUMENTS CONSIDERED TO BE RELEVANT | | | CLASSIFICATION OF THE APPLICATION (IPC) |
|---|---|---|---|
| Category | Citation of document with indication, where appropriate, of relevant passages | Relevant to claim | |
| Y | WO 2021/192158 A1 (SHARP KK [JP]) 30 September 2021 (2021-09-30) * abstract * | 14 | |
| E | & US 2023/134846 A1 (MIZUSAKI MASANOBU [JP] ET AL) 4 May 2023 (2023-05-04) * paragraph [0040] * ----- | 14 | |
| | | | TECHNICAL FIELDS SEARCHED (IPC) |

2

EPO FORM 1503 03.82 (P04C10)

page 2 of 2

Europäisches Patentamt
European Patent Office
Office européen des brevets

# INCOMPLETE SEARCH SHEET C

Application Number
EP 22 20 9654

**Claim(s) completely searchable:**
2-15

**Claim(s) not searched:**
1

**Reason for the limitation of the search:**

The present application contains two independent device claims 1 and 2. There is no clear distinction between the independent claims because of overlapping scope. There are so many claims and they are drafted in such a way that the claims as a whole do not comply with the provisions of clarity and conciseness in Article 84 EPC, as it is particularly burdensome for a skilled person to establish the subject-matter for which protection is sought. Non-compliance with the substantive provisions is such that a meaningful search of the whole claimed subject-matter could not be carried out (Rule 63 EPC and Guidelines B-VIII, 3).

## ANNEX TO THE EUROPEAN SEARCH REPORT ON EUROPEAN PATENT APPLICATION NO.

EP 22 20 9654

This annex lists the patent family members relating to the patent documents cited in the above-mentioned European search report. The members are as contained in the European Patent Office EDP file on
The European Patent Office is in no way liable for these particulars which are merely given for the purpose of information.

02-06-2023

| Patent document cited in search report | Publication date | Patent family member(s) | Publication date |
|---|---|---|---|
| US 2009211640 A1 | 27-08-2009 | KR 20090092114 A | 31-08-2009 |
| | | US 2009211640 A1 | 27-08-2009 |
| WO 2019176982 A1 | 19-09-2019 | JP WO2019176982 A1 | 25-02-2021 |
| | | WO 2019176982 A1 | 19-09-2019 |
| US 2018076397 A1 | 15-03-2018 | CN 107251260 A | 13-10-2017 |
| | | EP 3259786 A1 | 27-12-2017 |
| | | JP 6845799 B2 | 24-03-2021 |
| | | JP 2018512726 A | 17-05-2018 |
| | | KR 20170118170 A | 24-10-2017 |
| | | KR 20230006023 A | 10-01-2023 |
| | | TW 201641506 A | 01-12-2016 |
| | | US 2018076397 A1 | 15-03-2018 |
| | | US 2020280002 A1 | 03-09-2020 |
| | | WO 2016131918 A1 | 25-08-2016 |
| EP 3480192 B1 | 23-12-2020 | CN 111448188 A | 24-07-2020 |
| | | EP 3480192 A1 | 08-05-2019 |
| | | EP 3786159 A1 | 03-03-2021 |
| | | KR 20200084885 A | 13-07-2020 |
| | | US 2020365810 A1 | 19-11-2020 |
| | | WO 2019086568 A1 | 09-05-2019 |
| EP 3338314 B1 | 12-02-2020 | CN 107925013 A | 17-04-2018 |
| | | EP 3133664 A1 | 22-02-2017 |
| | | EP 3338314 A1 | 27-06-2018 |
| | | JP 6807379 B2 | 06-01-2021 |
| | | JP 2018530910 A | 18-10-2018 |
| | | KR 20180041695 A | 24-04-2018 |
| | | US 2018240995 A1 | 23-08-2018 |
| | | WO 2017029366 A1 | 23-02-2017 |
| WO 2021192158 A1 | 30-09-2021 | CN 115244598 A | 25-10-2022 |
| | | US 2023134846 A1 | 04-05-2023 |
| | | WO 2021192158 A1 | 30-09-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2722908 A1


### Non-patent literature cited in the description


- **ALLEN, LELAND C.** Electronegativity is the average one-electron energy of the valence-shell electrons in ground-state free atoms. *Journal of the American Chemical Society,* 1989, vol. 111 (25), 9003-9014
- *CHEMICAL ABSTRACTS,* 1242056-42-3
- *CHEMICAL ABSTRACTS,* 1613079-70-1